# EUROPEAN PATENT APPLICATION

(11) **EP 4 525 580 A1**
(43) Date of publication of application: **19.03.2025**
(21) Application number: 23814961.1
(22) Date of filing: 17.05.2023
(51) Int. Cl.: H10B 12/00, H05K 1/18

(54) **MEMORY AND PREPARATION METHOD FOR MEMORY**

(30) Priority: 02.06.2022 CN 202210621656
(71) Applicant: Huawei Technologies Co., Ltd., Shenzhen, Guangdong 518129 (CN)
(72) Inventor: BU, Sitong, Shenzhen, Guangdong 518129 (CN); FANG, Yichen, Shenzhen, Guangdong 518129 (CN); GAO, Qiang, Shenzhen, Guangdong 518129 (CN); DING, Shicheng, Shenzhen, Guangdong 518129 (CN); XU, Jeffrey Junhao, Shenzhen, Guangdong 518129 (CN)
(74) Representative: Thun, Clemens
(86) International application number: PCT/CN2023/094774
(87) International publication number: WO 2023/231776

(57) **Abstract**

A memory is disclosed, and includes a substrate (330), a first storage array (310), and a first redundant array (320). The first storage array (310) includes a stacked structure including at least one transistor and at least one capacitor unit, and the first storage array (310) is configured to store data. The first redundant array (320) includes a stacked structure including at least one transistor and at least one capacitor unit. Heights of the first redundant array (320) and the first storage array (310) relative to the substrate are the same, and the stacked structure of the first redundant array (320) is the same as the stacked structure of the first storage array (310). The redundant array having the same stacked structure as the storage array is disposed around the storage array, so that an ambient environment of an edge part of the storage array is similar to an ambient environment of a central part of the storage array. This avoids a deviation of a critical dimension caused by optical reflection and diffraction in a photolithography process, and can improve structural evenness of the memory.

## Description

This application claims priority to Chinese Patent Application No. 202210621656.X, filed with the China National Intellectual Property Administration on June 2, 2022 and entitled "MEMORY AND MEMORY PREPARATION METHOD", which is incorporated herein by reference in its entirety.

### TECHNICAL FIELD

Embodiments of this application relate to the memory field, and mainly to a memory and a memory preparation method.

### BACKGROUND

To meet a design for manufacturing (design for manufacturing, DFM) requirement, evenness and flatness of media at layers of a chip after a chemical mechanical planarization (chemical mechanical planarization, CMP) process need to be ensured. To reduce process manufacturing defects, some redundant structures irrelevant to a layout versus schematic (layout versus schematic, LVS) are usually added to an area without a metal interconnection line in a design layout. In a conventional solution in which a redundant structure is added to a back end metal layer by layer, environments around a storage array cannot be kept strictly consistent. Therefore, in a photolithography process, due to reflection and diffraction characteristics of light, a deviation of a critical dimension (critical dimension, CD) of an image at an edge of the storage array is large. In addition, because it is difficult for the redundant structure added layer by layer to be consistent with the image of the storage array, it cannot be ensured that density distribution of the redundant structure and the storage array is even. Therefore, metal layer dishing (dishing) and medium layer erosion (erosion) may occur after the CMP process. As a result, thickness of an inter layer dielectric (inter layer dielectric, ILD) fluctuates unevenly.

How to avoid the deviation caused by the photolithography process to the critical dimension of the storage array and improve evenness of a memory structure becomes an urgent problem to be resolved.

### SUMMARY

Embodiments of this application provide a memory and a memory preparation method, to reduce a deviation of a critical dimension of a storage array in a photolithography process, and improve structural evenness of the memory.

According to a first aspect, a memory is provided. The memory includes a substrate, a first storage array, and a first redundant array. The first storage array includes a stacked structure including at least one transistor and at least one capacitor unit, and the first storage array is configured to store data. Heights of the first redundant array and the first storage array relative to the substrate are the same. The first redundant array includes a stacked structure including at least one transistor and at least one capacitor unit. The stacked structure of the first redundant array is the same as the stacked structure of the first storage array.

In embodiments of this application, the redundant array having the same stacked structure as the storage array may be disposed at a height at which the storage array is located, so that an ambient environment of an edge part of the storage array is similar to an ambient environment of a central part of the storage array. This avoids a deviation of a critical dimension caused by optical reflection and diffraction in a photolithography process, and can improve structural evenness of the memory.

With reference to the first aspect, in some implementations of the first aspect, each of the stacked structures of the first storage array and the first redundant array includes an mTnC structure. The mTnC structure includes m transistors and n capacitor units that are stacked, and m and n are positive integers greater than or equal to 1.

In embodiments of this application, the storage array with the mTnC structure and the redundant array with the mTnC structure may be disposed. This can avoid the deviation of the critical dimension of the storage array caused in the photolithography process, and enable a structure of the memory to be more evenly distributed.

With reference to the first aspect, in some implementations of the first aspect, the at least one transistor of the first storage array and the at least one transistor of the first redundant array are disposed at a same layer, and the at least one capacitor unit of the first storage array and the at least one capacitor unit of the first redundant array are disposed at a same layer.

It should be understood that the same layer is a same wiring layer or a same multi-layer wiring layer.

In embodiments of this application, the transistor of the storage array and the transistor of the redundant array are disposed at the same layer, and the capacitor unit of the storage array and the capacitor unit of the redundant array are disposed at the same layer, so that the redundant array and the storage array have the same stacked structure. This avoids the deviation caused by the photolithography process, and improves evenness of structure distribution of the memory.

With reference to the first aspect, in some implementations of the first aspect, each of the stacked structures of the first storage array and the first redundant array further includes at least one of the following structures: a word line, a bit line, a plate line plane, or a pillar. Any one of the at least one transistor is connected to the word line, the bit line, or the pillar. Alternatively, any one of the at least one capacitor unit is disposed at an intersection point between the plate line plane and the pillar.

In embodiments of this application, a redundant array including a transistor, a capacitor unit, and at least one structure of the word line, the bit line, the plate line plane, or the pillar may be disposed, so that the ambient environment of the edge part of the storage array is consistent with the ambient environment of the central part of the storage array. This avoids an error caused by the photolithography process, and improves structural evenness of the memory.

With reference to the first aspect, in some implementations of the first aspect, the first storage array is electrically connected to an external circuit outside the memory, and the first redundant array is disposed in an open circuit or is not electrically connected to a circuit in the memory.

In embodiments of this application, although the redundant array has the same stacked structure as the storage array, because the redundant array is disposed in the open circuit or is not electrically connected to the circuit in the memory, the redundant array cannot store data, that is, has no substantive function like data storage.

With reference to the first aspect, in some implementations of the first aspect, the memory further includes a first metal structure, a first redundant structure, and a first via. Heights of the first metal structure and the first redundant structure relative to the substrate are the same, and the height of the first redundant structure relative to the substrate is lower than the height of the first redundant array relative to the substrate. The first via is configured to connect the first redundant structure and the first redundant array.

In embodiments of this application, the first redundant structure located at the same height as the first metal structure may be added, so that a structure of a height layer at which the first metal structure is located is more even. This reduces a fluctuation degree of the layer after a CMP process. In addition, the first via connecting the first redundant structure and the first redundant array may be added. This releases plasma generated in the process, and avoids damage to a device.

With reference to the first aspect, in some implementations of the first aspect, the memory further includes a second metal structure, a second redundant structure, and a second via. Heights of the second metal structure and the second redundant structure relative to the substrate are the same, and the height of the second redundant structure relative to the substrate is higher than the height of the first redundant array relative to the substrate. The second via is configured to connect the second redundant structure and the first redundant array.

In embodiments of this application, the second redundant structure located at the same height as the second metal structure may be added. This improves structure evenness of the height layer at which the second metal structure is located, and further improves smoothness of the layer after the CMP process. In addition, the second via connecting the second redundant structure and the first redundant array may be added. This provides a discharge channel for the plasma generated in the process, and improves reliability of the device.

According to a second aspect, a memory preparation method is provided. The method includes: forming a substrate of a memory; forming a first storage array and a first redundant array at a same height relative to the substrate. The first storage array includes a stacked structure including at least one transistor and at least one capacitor unit, the first storage array is configured to store data, and the first redundant array includes a stacked structure including at least one transistor and at least one capacitor unit. The stacked structure of the first redundant array is the same as the stacked structure of the first storage array.

In embodiments of this application, the first redundant array having the same stacked structure as the first storage array may be added to a same height of the first storage array. This avoids a deviation of a critical dimension caused in a photolithography process, protects an edge part of the storage array, and improves structural evenness of the memory.

With reference to the second aspect, in some implementations of the second aspect, each of the stacked structures of the first storage array and the first redundant array includes an mTnC structure. The mTnC structure includes m transistors and n capacitor units that are stacked, and m and n are positive integers greater than or equal to 1.

In embodiments of this application, the storage array with the mTnC structure and the redundant array with the mTnC structure may be formed. This can avoid the deviation of the critical dimension of the storage array caused in the photolithography process, and enable a structure of the memory to be more evenly distributed.

With reference to the second aspect, in some implementations of the second aspect, the at least one transistor of the first storage array and the at least one transistor of the first redundant array are formed at a same layer of the first storage array and the first redundant array, and the at least one capacitor unit of the first storage array and the at least one capacitor unit of the first redundant array are formed at a same layer of the first storage array and the first redundant array.

In embodiments of this application, the transistor and the capacitor are formed at the same layer of the first storage array and the first redundant array, so that the first storage array and the first redundant array have the same stacked structure. This can avoid an error caused by the photolithography process, and improve evenness of structure distribution of the memory.

With reference to the second aspect, in some implementations of the second aspect, each of the stacked structures of the first storage array and the first redundant array further includes at least one of the following structures: a word line, a bit line, a plate line plane, or a pillar. Any one of the at least one transistor is connected to the word line, the bit line, or the pillar. Alternatively, any one of the at least one capacitor unit is disposed at an intersection point between the plate line plane and the pillar.

In embodiments of this application, a redundant array including a transistor, a capacitor unit, and at least one structure of the word line, the bit line, the plate line plane, or the pillar may be formed, so that an ambient environment of an edge part of the storage array is consistent with an ambient environment of a central part of the storage array. This avoids an error caused by the photolithography process, and improves structural evenness of the memory.

With reference to the second aspect, in some implementations of the second aspect, the first storage array is electrically connected to an external circuit outside the memory, and the first redundant array is disposed in an open circuit or is not electrically connected to a circuit in the memory.

In embodiments of this application, although the redundant array has the same stacked structure as the storage array, because the redundant array is disposed in the open circuit or is not electrically connected to the circuit in the memory, the redundant array cannot store data, that is, has no substantive function like data storage.

With reference to the second aspect, in some implementations of the second aspect, a first metal structure and a first redundant structure are formed at a same height relative to the substrate, and the height of the first redundant structure relative to the substrate is lower than the height of the first redundant array relative to the substrate. A first via is formed, and the first via is configured to connect the first redundant structure and the first redundant array.

In embodiments of this application, the first redundant structure located at the same height as the first metal structure may be formed, so that a structure of a height layer at which the first metal structure is located is more even. This reduces a fluctuation degree of the layer after a CMP process. In addition, the first via connecting the first redundant structure and the first redundant array may be formed. This releases plasma generated in a process, and avoids damage to a device.

With reference to the second aspect, in some implementations of the second aspect, a second via is formed, and the second via is configured to connect a second redundant structure and the first redundant array. A second metal structure and the second redundant structure are formed at a same height relative to the substrate, and the height of the second redundant structure relative to the substrate is higher than the height of the first redundant array relative to the substrate.

In embodiments of this application, the second redundant structure located at the same height as the second metal structure may be formed. This improves structure evenness of the height layer at which the second metal structure is located, and further improves smoothness of the layer after the CMP process. In addition, the second via connecting the second redundant structure and the first redundant array may be formed. This provides a discharge channel for the plasma generated in the process, and improves reliability of the device.

According to a third aspect, a memory is provided, including a controller and the first storage array and the first redundant array according to the first aspect, where the controller is electrically connected to the first storage array.

According to a fourth aspect, an electronic device is provided, including a circuit board and the memory according to the first aspect.

According to a fifth aspect, an electronic device is provided, including a circuit board and the memory according to the third aspect.

### BRIEF DESCRIPTION OF DRAWINGS

FIG. 1 is a schematic cross-sectional view of a back end integrated ferroelectric random access memory;
FIG. 2 is a diagram of a structure of a storage array of a 1TnC structure;
FIG. 3 is a schematic of a circuit of a storage array of a 1TnC structure;
FIG. 4 is a diagram of metal layer dishing and dielectric layer erosion;
FIG. 5 is a diagram of a structure of a memory 300 according to an embodiment of this application;
FIG. 6 is a diagram of a structure of a memory 400 according to another embodiment of this application;
FIG. 7 is a diagram of a structure of a memory 500 according to still another embodiment of this application;
FIG. 8 is a schematic cross-sectional view of a memory to which a redundant array is added according to an embodiment of this application;
FIG. 9 is a schematic cross-sectional view of a memory to which a via is added according to an embodiment of this application;
FIG. 10 is a schematic flowchart of a memory preparation method according to an embodiment of this application; and
FIG. 11 is a schematic flowchart of a memory preparation method according to another embodiment of this application.

### DESCRIPTION OF EMBODIMENTS

The following describes technical solutions of embodiments in this application with reference to accompanying drawings.

The technical solutions in embodiments of this application are applied to various back end integrated memories, such as a back end integrated ferroelectric random access memory (ferroelectric random access memory, FRAM), a back end integrated static random access memory (static random access memory, SRAM), a back end integrated dynamic random access memory (dynamic random access memory, DRAM), a back end integrated electrically erasable programmable read-only memory (Electrically Erasable Programmable read-only memory, EEPROM), and the like. This is not limited in embodiments of this application.

Descriptions are provided below by using an example in which embodiments of this application are applied to the back end integrated FRAM. However, embodiments of this application may also be applied to the foregoing various back end integrated memories.

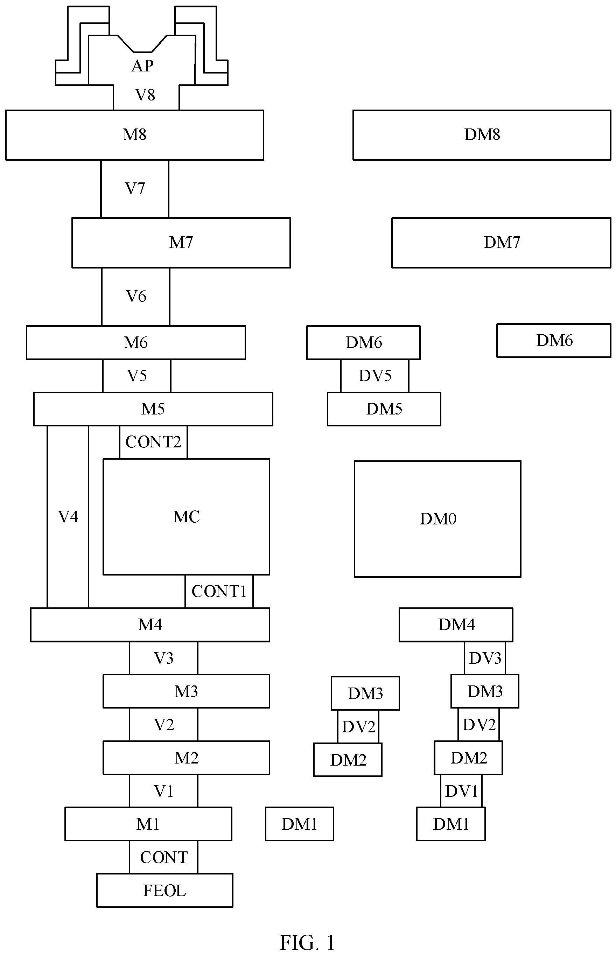

FIG. 1 is a schematic cross-sectional view of a back end integrated FRAM. In FIG. 1, a front end of line (front end of line, FEOL), a via CONT, a metal structure M1, a via V1, a metal structure M2, a via V2, a metal structure M3, a via V3, a metal structure M4, a via V4, a via CONT1, a storage array MC, a via CONT2, a metal structure M5, a via V5, a metal structure M6, a via V6, a metal structure M7, a via V7, a metal structure M8, a via V8, and an aluminum pad (aluminum pad, AP) are included. In addition, in FIG. 1, two redundant structures DM1, a via DV1, two redundant structures DM2, two vias DV2, two redundant structures DM3, a via DV3, a redundant structure DM4, a redundant structure DM0, a redundant structure DM5, a via DV5, two redundant structures DM6, a redundant structure DM7, and a redundant structure DM8 are further included.

Any one of the metal structures M1 to M8 is configured to conduct electricity, and may be a metal conducting wire. Any one of the vias V1 to V8, CONT, CONT1, and CONT2 includes a conductive material, and may be configured to conduct electricity. The redundant structures DM1 to DM8 and DM0 may be metal blocks, and a material of the redundant structure is similar to or the same as a material of a metal structure at a same height. For example, the two redundant structures DM1 are located at a same height layer as M1, and materials of the two redundant structures DM1 are similar to or the same as a material of M1. Any one of the vias DV1 to DV3 and DV5 includes a conductive material, and may be configured to conduct electricity.

It should be understood that a meaning of "the metal structure and the redundant structure are located at a same height or a same height layer" is similar to a meaning of "heights of the metal structure and the redundant structure relative to a substrate are the same". "A height or a height layer at which the metal structure is located is higher than a height or a height layer at which the redundant structure is located" is similar to "a height of the metal structure relative to the substrate is higher than a height of the redundant structure relative to the substrate".

It should be further understood that a height relative to the substrate is an interval instead of a specific value.

The front end of line FEOL may be a substrate in various forms, for example, may be a silicon substrate, a bulk semiconductor material substrate, a semiconductor-on-insulator substrate, or a compound semiconductor substrate. This is not limited in embodiments of this application. The front end of line FEOL is located at a lowest height layer in a cross section shown in FIG. 1. In an actual manufacturing process, the height layer at which the FEOL is located is lower than a height layer at which a structure other than the FEOL shown in FIG. 1 is located.

The via CONT is disposed between the FEOL and the metal structure M1, that is, the CONT is located in a direction in which the FEOL faces the storage array MC. The CONT may connect the FEOL and the M1, and may be further configured to conduct electricity. In an actual manufacturing process, a height layer at which the CONT is located is higher than the height layer at which the FEOL is located, that is, the CONT is higher than the FEOL. It should be understood that a height of the CONT may be understood as a height of the CONT relative to the FEOL.

The metal structure M1 is located in a direction in which the CONT faces the storage array MC. In an actual manufacturing process, a height layer at which the metal structure M1 is located is higher than the height layer at which the CONT is located, that is, the M1 is higher than the CONT. It should be understood that the height of the M1 may be understood as a height of the M1 relative to the FEOL.

Both the two redundant structures DM1 and the metal structure M1 are located at a same height layer. In an actual manufacturing process, the height layer at which the two redundant structures DM1 are located is higher than the height layer at which the CONT is located.

The via V1 is disposed between the metal structures M1 and M2, that is, the V1 is located in a direction in which the M1 faces the storage array MC. The V1 may connect the M1 and the M2, and may be further configured to conduct electricity. In an actual manufacturing process, a height layer at which the V1 is located is higher than the height layer at which the M1 is located.

The via DV1 is disposed between one DM1 of the two redundant structures DM1 and the DM2, and the DV1 and the via V1 are located at a same height layer. The DV1 is disposed in a direction in which the two redundant structures DM1 face the storage array MC. In an actual manufacturing process, the height layer at which the DV1 is located is higher than the height layer at which the two redundant structures DM1 are located.

The metal structure M2 is located in a direction in which the V1 faces the storage array MC. In an actual manufacturing process, a height layer at which the metal structure M2 is located is higher than the height layer at which the V1 is located.

Both the two redundant structures DM2 and the metal structure M2 are located at a same height layer. In an actual manufacturing process, the height layer at which the two redundant structures DM2 are located is higher than the height layer at which the DV1 is located.

The via V2 is disposed between the metal structures M2 and M3, that is, the V2 is located in a direction in which the M2 faces the storage array MC. The V2 may connect the M2 and the M3, and may be further configured to conduct electricity. In an actual manufacturing process, a height layer at which the V2 is located is higher than the height layer at which the M2 is located.

Either of the two vias DV2 is disposed between one redundant structure DM2 and one redundant structure DM3, and the two vias DV2 and the via V2 are located at a same height layer. The two vias DV2 are both disposed in a direction in which the two redundant structures DM2 face the storage array MC. In an actual manufacturing process, the height layer at which the two vias DV2 are located is higher than the height layer at which the two redundant structures DM2 are located.

The metal structure M3 is located in a direction in which the V2 faces the storage array MC. In an actual manufacturing process, a height layer at which the metal structure M3 is located is higher than the height layer at which the V2 is located.

The two redundant structures DM3 and the metal structure M3 are located at a same height layer. In an actual manufacturing process, the height layer at which the two redundant structures DM3 are located is higher than the height layer at which the two vias DV2 are located.

The via V3 is disposed between the metal structures M3 and M4, that is, the V3 is located in a direction in which the M3 faces the storage array MC. The V3 may connect the M3 and the M4, and may be further configured to conduct electricity. In an actual manufacturing process, a height layer at which the V3 is located is higher than the height layer at which the M3 is located.

The via DV3 is disposed between one DM3 of the two redundant structures DM3 and the DM4, and the DV3 and the via V3 are located at a same height layer. The DV3 is disposed in a direction in which the two redundant structures DM3 face the storage array MC. In an actual manufacturing process, a height layer at which the DV3 is located is higher than the height layer at which the two redundant structures DM3 are located.

The metal structure M4 is located in a direction in which the V3 faces the storage array MC. In an actual manufacturing process, a height layer at which the metal structure M4 is located is higher than the height layer at which the V3 is located.

The redundant structure DM4 and the metal structure M4 are located at a same height layer. In an actual manufacturing process, the height layer at which the DM4 is located is higher than the height layer at which the DV3 is located.

The via CONT1 is disposed between the metal structure M4 and the storage array MC, that is, the CONT1 is located in a direction in which the M4 faces the storage array MC. The CONT1 may be connected to the M4 and the storage array MC, and may be further configured to conduct electricity. In an actual manufacturing process, a height layer at which the CONT1 is located is higher than the height layer at which the M4 is located.

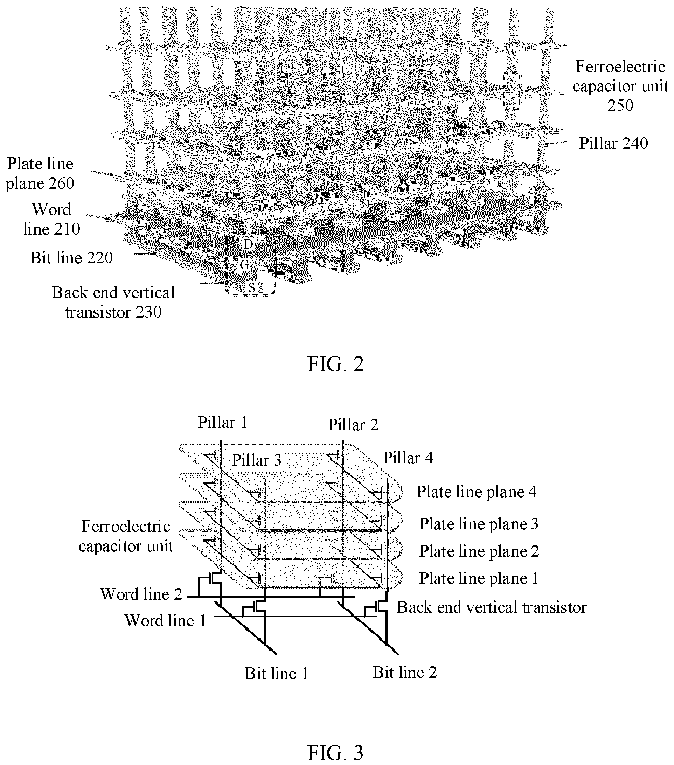

The storage array MC is disposed between the vias CONT1 and CONT2. In an actual manufacturing process, a height layer at which the storage array MC is located is higher than the height layer at which the CONT1 is located. The storage array MC has a stacked structure including at least one transistor and at least one capacitor unit, and may be configured to store data. In the ferroelectric random access memory, the storage array MC may have a structure of 1 transistor and n capacitor units (1 transistor n capacitance, 1TnC) or a structure of m transistors and n capacitor units (m transistor n capacitance, mTnC) shown in FIG. 2, where n and m are positive integers greater than or equal to 1.

The via CONT2 is disposed between the storage array MC and the metal structure M5, that is, the CONT2 is located in a direction in which the storage array MC is away from the FEOL. The CONT2 may connect the M5 and the storage array MC, and may be further configured to conduct electricity. In an actual manufacturing process, a height layer at which the CONT2 is located is higher than the height layer at which the storage array MC is located.

The via V4 is disposed in a part between the metal structures M4 and M5 other than the storage array MC, the CONT1, and the CONT2. The V4 may connect the M4 and the M5, and may be further configured to conduct electricity. In an actual manufacturing process, a height layer at which the V4 is located is higher than the height layer at which the M4 is located.

The redundant structure DM0 and the storage array MC are located at a same height layer, and the DM0 is a metal block or a metal sheet. In an actual manufacturing process, the height layer at which the DM0 is located is higher than the height layer at which the CONT1 is located.

The metal structure M5 is located in a direction in which the V4 is away from the storage array MC. In an actual manufacturing process, a height layer at which the metal structure M5 is located is higher than the height layer at which the V4 is located.

The redundant structure DM5 and the metal structure M5 are located at a same height layer. In an actual manufacturing process, the height layer at which the DM5 is located is higher than the height layer at which the DM0 is located.

The via V5 is disposed between the metal structures M5 and M6, that is, V5 is located in a direction in which the M5 is away from the storage array MC. The V5 may connect the M5 and the M6, and may be further configured to conduct electricity. In an actual manufacturing process, a height layer at which the V5 is located is higher than the height layer at which the M5 is located.

The via DV5 is disposed between the redundant structure DM5 and one DM6 of the two redundant structures DM6, and the DV5 and the via V5 are located at a same height layer. The DV5 is disposed in a direction in which the DM5 is away from the storage array DM0. In an actual manufacturing process, the height layer at which the DV5 is located is higher than the height layer at which the DM5 is located.

The metal structure M6 is located in a direction in which the V5 is away from the storage array MC. In an actual manufacturing process, a height layer at which the metal structure M6 is located is higher than the height layer at which the V5 is located.

The two redundant structures DM6 and the metal structure M6 are located at a same height layer. In an actual manufacturing process, the height layer at which the two redundant structures DM6 are located is higher than the height layer at which the DV5 is located.

The via V6 is disposed between the metal structures M6 and M7, that is, the V6 is located in a direction in which the M6 is away from the storage array MC. The V6 may connect the M6 and the M7, and may be further configured to conduct electricity. In an actual manufacturing process, a height layer at which the V6 is located is higher than the height layer at which the M6 is located.

The metal structure M7 is located in a direction in which the V6 is away from the storage array MC. In an actual manufacturing process, a height layer at which the metal structure M7 is located is higher than the height layer at which the V6 is located.

The redundant structure DM7 and the metal structure M7 are located at a same height layer. In an actual manufacturing process, the height layer at which the DM7 is located is higher than the height layer at which the DM6 is located.

The via V7 is disposed between the metal structures M7 and M8, that is, the V7 is located in a direction in which the M7 is away from the storage array MC. The V7 may connect the M7 and the M8, and may be further configured to conduct electricity. In an actual manufacturing process, a height layer at which the V7 is located is higher than the height layer at which the M7 is located.

The metal structure M8 is located in a direction in which the V7 is away from the storage array MC. In an actual manufacturing process, a height layer at which the metal structure M8 is located is higher than the height layer at which the V7 is located.

The redundant structure DM8 and the metal structure M8 are located at a same height layer. In an actual manufacturing process, a height layer at which the DM8 is located is higher than the height layer at which the DM7 is located.

The via V8 is disposed between the aluminum pad AP and the M8, that is, the V8 is located in a direction in which the M8 is away from the storage array MC. The V8 may connect the AP and the M8, and may be further configured to conduct electricity. In an actual manufacturing process, a height layer at which the V8 is located is higher than the height layer at which the M8 is located.

The aluminum pad AP is located in a direction in which the V8 is away from the storage array MC. In an actual manufacturing process, a height layer at which the AP is located is higher than the height layer at which the V8 is located. The AP may be configured to conduct electricity.

An environment difference between an edge part and a central part of the storage array MC in FIG. 1 is large. As a result, in a photolithography process, a deviation of a critical dimension of the storage array MC is easily caused due to optical reflection and diffraction. In addition, because a structure of the memory in FIG. 1 is unevenly distributed, serious metal layer dishing or dielectric layer erosion easily occurs in a CMP process.

FIG. 2 is a diagram of a structure of a storage array of a 1TnC structure. The storage array shown in FIG. 2 includes a word line 210, a bit line 220, a back end vertical transistor 230, a pillar 240, a ferroelectric capacitor unit 250, and a plate line plane 260.

The word line (word line, WL) 210 and the bit line (bit line, BL) 220 are two metal lines that are vertically interleaved at a bottom layer of the storage array. The back end vertical transistor 230 may be connected to the word line 210, the bit line 220, and the pillar 240. The back end vertical transistor 230 includes a source (Source) S, a gate (Gate) G, and a drain (Drain) D. The source S is connected to the bit line 220, the gate G is connected to the word line 210, and the drain D is connected to the pillar 240.

The plate line plane 260 is located at an upper layer of the word line 210, the bit line 220, and the back end vertical transistor 230. The storage array shown in FIG. 2 includes n plate line planes 260 and a plurality of pillars 240, where n is a positive integer greater than or equal to 1. Each pillar 240 may penetrate the n plate line planes 260. An overlapping point between each pillar 240 and each plate line plane 260 is the ferroelectric capacitor unit 250. The ferroelectric capacitor unit 250 is formed by a plate line in each plate line plane 260, the pillar 240, and a ferroelectric crystal thin film. The plate line in each plate line plane 260 and the pillar 240 that penetrates the plate line plane 260 are two stages of the ferroelectric capacitor unit 250, and the ferroelectric crystal thin film surrounds the overlapping point. Because the ferroelectric crystal thin film may have different polarization states, the ferroelectric capacitor unit 250 may record different storage information via different polarization states of the ferroelectric crystal thin film. In other words, one ferroelectric capacitor unit 250 is one storage unit of the storage array.

The 1TnC structure of the storage array shown in FIG. 2 includes n ferroelectric capacitor units 250 on one pillar 240 and one back end vertical transistor connected to a lower end of the pillar 240.

FIG. 3 is a schematic of a circuit of a storage array of a 1TnC structure. FIG. 3 includes two word lines, two bit lines, four plate line planes, four pillars, four back end vertical transistors, and a plurality of ferroelectric capacitor units. In a direction of one pillar in FIG. 3, there is one back end vertical transistor and n ferroelectric capacitor units, where a value of n is 4. A word line 1 and a word line 2 in FIG. 3 are similar to the word line 210 in FIG. 2. A bit line 1 and a bit line 2 in FIG. 3 are similar to the bit line 220 in FIG. 2. The back end vertical transistor in FIG. 3 is similar to the back end vertical transistor 230 in FIG. 2. A pillar 1, a pillar 2, a pillar 3, and a pillar 4 in FIG. 3 are similar to the pillar 240 in FIG. 2. The ferroelectric capacitor unit in FIG. 3 is similar to the ferroelectric capacitor unit 250 in FIG. 2. A plate line plane 1, a plate line plane 2, a plate line plane 3, and a plate line plane 4 in FIG. 3 are similar to the plate line plane 260 in FIG. 2.

Because metal and dielectric density distribution of a layer at which each metal structure is located in the memory 100 is uneven, metal layer dishing (dishing) or dielectric layer erosion (erosion) phenomenon occurs after a CMP process, causing uneven thickness of each layer. In this way, many defects are easily generated in a manufacturing process. In addition, because ambient environments of a central part and an edge part of a first storage array 120 are inconsistent, in a photolithography process, a deviation of a critical dimension of the first storage array 120 is easily caused due to optical reflection and diffraction. For example, the first storage array 120 should include 1024×1024 storage units, but an actually produced first storage array 120 includes only 1000×990 storage units.

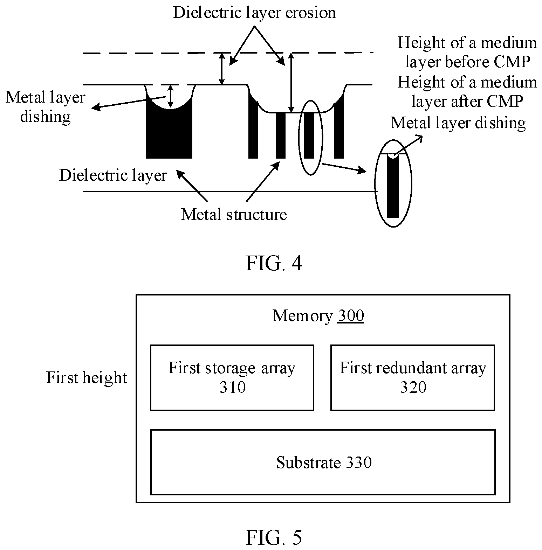

FIG. 4 is a diagram of metal layer dishing and dielectric layer erosion. FIG. 4 includes a plurality of metal structures and a dielectric layer. The plurality of metal structures are located at the dielectric layer, and a part other than the plurality of metal structures in the dielectric layer is a dielectric.

Before a CMP process, upper-layer edges of the plurality of metal structures are flush with an upper-layer edge of the dielectric layer. A height of the dielectric layer after the CMP process is lower than a height of the dielectric layer before the CMP process, that is, dielectric layer erosion occurs. In addition, after the CMP process, the upper-layer edges of the plurality of metal structures are lower than the upper-layer edge of the dielectric layer. In other words, metal layer dishing occurs between the upper-layer edges of the plurality of metal structures and the upper-layer edge of the dielectric layer. In addition, because density distribution of the plurality of metal structures and the dielectric in FIG. 4 is uneven, after the CMP process, a thickness of the dielectric layer is uneven, and there are many defects.

To protect an edge part of a storage array, avoid a deviation of a critical dimension caused by optical reflection and diffraction in a photolithography process, and increase smoothness of each layer in the memory after the CMP process, an embodiment of this application provides a memory.

FIG. 5 is a diagram of a structure of a memory 300 according to an embodiment of this application. The memory 300 includes a first storage array 310, a first redundant array 320, and a substrate 330.

The first storage array 310 includes a stacked structure including at least one transistor and at least one capacitor unit, and the first storage array 310 may be configured to store data. The first storage array 310 may be similar to the storage array MC in FIG. 1.

The first redundant array 320 includes a stacked structure including at least one transistor and at least one capacitor unit. Heights of the first redundant array 320 and the first storage array 310 relative to the substrate 330 are the same, in other words, the first redundant array 320 and the first storage array 310 are located at a same height layer, and the first redundant array 320 has a same layered structure or stacked structure as the first storage array 310. It should be understood that a meaning of the layered structure is similar to that of the stacked structure. It should be further understood that the heights of the first redundant array 320 and the first storage array 310 relative to the substrate 330 are an interval instead of a specific value.

For example, the heights of the first redundant array 320 and the first storage array 310 relative to the substrate 330 are a first height, in other words, the first redundant array 320 and the first storage array 310 may be located at a first height layer, and the first redundant array 320 and the first storage array 310 may have a same stacked structure. In this way, ambient environments of an edge part and a central part of the first storage array 310 are similar. The first redundant array 320 and the first storage array 310 have a same stacked structure, so that a structure of the first height layer is even. This can improve smoothness of the layer after a CMP process.

Optionally, the stacked structure may include an mTnC structure. The mTnC structure includes m transistors and n capacitor units that are stacked, and m and n are positive integers greater than or equal to 1.

Optionally, the at least one transistor of the first storage array 310 and the at least one transistor of the first redundant array 320 are disposed at a same layer. The at least one capacitor unit of the first storage array 310 and the at least one capacitor unit of the first redundant array are disposed at a same layer. The same layer may be a same wiring layer, or may be a same multi-layer wiring layer. This is not limited in this embodiment of this application.

For example, assuming that four transistors are disposed in a first wiring layer in the first storage array 310, four transistors are also disposed in a first wiring layer in the first redundant array 320. In addition, an arrangement structure of the four transistors in the first redundant array 320 is the same as an arrangement structure of the four transistors in the first storage array 310. Alternatively, assuming that four capacitor units are further disposed at a second wiring layer in the first storage array 310, four capacitor units are also disposed at a second wiring layer in the first redundant array 320. In addition, an arrangement structure of the four transistors and the four capacitor units in the first redundant array 320 is the same as an arrangement structure of the four transistors and the four capacitor units in the first storage array 310.

Optionally, each of the stacked structures of the first storage array and the first redundant array may further include at least one of the following structures: a word line, a bit line, a plate line plane, or a pillar. Any one of the at least one transistor is connected to the word line, the bit line, or the pillar. Alternatively, any one of the at least one capacitor unit is disposed at an intersection point between the plate line plane and the pillar.

It should be understood that, on a basis that the first redundant array 320 has the same stacked structure as the first storage array 310, the first redundant array 320 may have electronic components completely the same as those of the first storage array 310, or may have some electronic components same as those of the first storage array 310.

For example, it is assumed that the memory is a ferroelectric random access memory, and the first storage array 310 includes all electronic components in the 1TnC structure shown in FIG. 2, such as the word line, the bit line, the plate line plane, the pillar, the transistor, and the capacitor unit. In this case, the first redundant array 320 may also include all electronic components in the 1TnC structure shown in FIG. 2. Alternatively, the first redundant array may include some electronic components in the 1TnC structure shown in FIG. 2.

Optionally, the first storage array 310 may be electrically connected to an external circuit outside the memory. Alternatively, the first storage array 310 may be located in a closed circuit, that is, a circuit in which the first storage array 310 is located is a closed circuit. Alternatively, the first storage array 310 cannot be in an open circuit, that is, a circuit in which the first storage array 310 is located cannot be an open circuit. Because the first storage array 310 may be electrically connected to the external circuit outside the memory, the first storage array 310 may be configured to store data, that is, has a substantive function like data storage.

Optionally, the first redundant array 320 cannot be electrically connected to the external circuit outside the memory or a circuit in the memory. Alternatively, the first redundant array 320 cannot be located in a closed circuit, that is, a circuit in which the first redundant array 320 is located is not a closed circuit. Alternatively, the first redundant array 320 may be in an open circuit, that is, a circuit in which the first redundant array 320 is located is an open circuit. Although the first redundant array 320 has the same stacked structure as the first storage array 310, the first redundant array 320 cannot be electrically connected to the external circuit outside the memory. Therefore, the first redundant array 320 cannot be configured to store data, that is, has no substantive function like data storage.

A size of the first redundant array 320 may be the same as or similar to a size of the first storage array 310 in a first dimension. The size of the first redundant array 320 in the first dimension may include a length, a width, a height, a volume, a quantity of arrays of included storage units, and the like. For example, the size of the first redundant array 320 in the first dimension may be the same as the size of the first storage array 310 in the first dimension. Alternatively, an absolute value of a difference between the size of the first redundant array 320 in the first dimension and the size of the first storage array 310 in the first dimension may be less than a first threshold, and the first threshold is a non-negative number.

For example, that the size of the first redundant array 320 in the first dimension is the same as the size of the first storage array 310 in the first dimension may include: The length of the first redundant array 320 is the same as a length of the first storage array 310, the volume of the first redundant array 320 is the same as a volume of the first storage array 310, or the quantity of arrays of storage units included in the first redundant array 320 is the same as a quantity of arrays of storage units included in the first storage array 310, or the like. This is not limited in this embodiment of this application.

That the absolute value of the difference between the size of the first redundant array 320 in the first dimension and the size of the first storage array 310 in the first dimension is less than the first threshold may include: A difference between the size of the first redundant array 320 in the first dimension and the size of the first storage array 310 in the first dimension is less than the first threshold, or a difference between the size of the first storage array 310 in the first dimension and the size of the first redundant array 320 in the first dimension is less than the first threshold. This is not limited in this embodiment of this application.

That the difference between the size of the first redundant array 320 in the first dimension and the size of the first storage array 310 in the first dimension is less than the first threshold may include: A difference between the length of the first redundant array 320 and the length of the first storage array 310 is less than the first threshold, a difference between the width of the first redundant array 320 and the width of the first storage array 310 is less than the first threshold, a difference between the height of the first redundant array 320 and the height of the first storage array 310 is less than the first threshold, or a difference between the quantity of arrays of storage units included in the first redundant array 320 and the quantity of arrays of storage units included in the first storage array 310 is less than the first threshold. This is not limited in this embodiment of this application.

That the difference between the size of the first redundant array 320 in the first dimension and the size of the first storage array 310 in the first dimension is less than the first threshold is similar to the foregoing description, and details are not described herein again.

First thresholds may be the same or may be different based on different actual requirements or different CMP processes. This is not limited in this embodiment of this application. For example, if the difference between the length of the first redundant array 320 and the length of the first storage array 310 is less than the first threshold, the first threshold may be 100 nanometers (nanometer, nm). If the difference between the quantity of arrays included in the first redundant array 320 and the quantity of arrays included in the first storage array 310 is less than the first threshold, the first threshold may be 50×50.

If the first threshold is large, the difference between the size of the first redundant array 320 and the size of the first storage array 310 in the first dimension is large. As a result a structure of the layer is uneven, and the ambient environments of the edge part and the central part of the first storage array 310 are inconsistent. Because the structure of the layer is uneven, smoothness of the layer is low after the CMP process. Because the ambient environments of the edge part and the central part of the first storage array 310 are inconsistent, in a photolithography process, a deviation in a critical dimension of the first storage array 310 easily occurs. If the first threshold is small, the difference between the size of the first redundant array 320 and the size of the first storage array 310 in the first dimension is small, so that the structure of the layer can be even, and the ambient environments of the edge part and the central part of the first storage array 310 can be consistent. However, to enable the difference between the size of the first redundant array 320 and the size of the first storage array 310 in the first dimension small, a precise preparation technology is required, and a long time may be required in a preparation process.

When the difference between the size of the first redundant array 320 in the first dimension and the size of the first storage array 310 in the first dimension is less than the first threshold, the first redundant array 320 may be divided into a first part and a second part. The first part of the first redundant array 320 is a part whose quantity of arrays of storage units and stacked structure are the same as those of the first storage array 310, that is, the quantity of arrays of storage units and the stacked structure included in the first part of the first redundant array 320 are the same as those of the first storage array 310. The second part of the first redundant array 320 may be any one of an mT structure, an nC structure, or an mTnC structure. The mT structure includes m back end vertical transistors 230 shown in FIG. 2, and the nC structure includes n ferroelectric capacitor units 250 shown in FIG. 2. The second part of the first redundant array 320 is connected to the first part.

For example, the first storage array 310 is of a 1TnC structure. The first part of the first redundant array 320 may be the 1TnC structure, and the second part of the first redundant array 320 may be one or more back end vertical transistors 230 shown in FIG. 2 that are at a lower end of the first part and that are connected to the 1T structure in the first part. Alternatively, the second part of the first redundant array 320 may be one or more ferroelectric capacitor units 250 shown in FIG. 2 that are at an upper end of the first part and that are connected to the nC structure in the first part. Alternatively, the second part of the first redundant array 320 may be one or more 1TnC structures that are at a left end of the first part and that are connected to the 1TnC structure at the left end of the first part. Alternatively, the second part of the first redundant array 320 may be one or more 1TnC structures that are at a right end of the first part and that are connected to the 1TnC structure at the right end of the first part.

A spacing between the first redundant array 320 and the first storage array 310 may be less than a sixth threshold. Sixth thresholds may be the same or may be different based on different CMP processes. This is not limited in this embodiment of this application. For example, a value range of the sixth threshold may be 1 micrometer to 10 micrometers. If the sixth threshold is large, the spacing between the first redundant array 320 and the first storage array 310 is large. The structure of the layer is uneven, and the layer is unsmooth after the CMP process. If the sixth threshold is small, the spacing between the first redundant array 320 and the first storage array 310 is small, and the structure of the layer may be uneven. In addition, a leakage problem may occur in a process of preparing the memory.

Optionally, the stacked structure of the first redundant array 320 and the stacked structure of the first storage array 310 may be the same, and the first redundant array 320 may include only a metal conducting wire. Alternatively, the stacked structure of the first redundant array 320 and the stacked structure of the first storage array 310 may be the same, and the first redundant array 320 may include an electronic component similar to the electronic component included in the first storage array 310. For example, assuming that the first storage array 310 is of the 1TnC structure shown in FIG. 2, the first redundant array 320 may include an electronic component similar to a transistor (that is, the back end vertical transistor 230) or a capacitor unit (that is, the ferroelectric capacitor unit 250) included in the 1TnC structure shown in FIG. 2. However, the transistor or the capacitor unit in the first redundant array 320 may not implement an essential function like storage.

Optionally, the memory 100 may further include a second redundant array. The second redundant array may be located at a same height layer as the first storage array 310 and the first redundant array 320. For example, when the first storage array 310 and the first redundant array 320 are located at the first height layer, the second redundant array is also located at the first height layer.

The second redundant array may be located on the other side that is of the first storage array 310 and that is away from the first redundant array 320, that is, the second redundant array may be located on a left side of the first storage array 310 shown in FIG. 5. The second redundant array may have a same layered structure or stacked structure as the first storage array 310. A size of the second redundant array in the first dimension may be the same as or similar to the size of the first storage array 310 in the first dimension. A relationship between the size of the second redundant array in the first dimension and the size of the first storage array 310 in the first dimension is similar to a relationship between the size of the first redundant array 320 in the first dimension and the size of the first storage array 310 in the first dimension. Details are not described herein again. A spacing between the second redundant array and the first storage array may be less than the sixth threshold, that is, may be similar to the spacing between the first redundant array and the first storage array. Details are not described herein again.

Optionally, the memory 100 may further include a third redundant array. The third redundant array may be located on a side that is of the first redundant array and that is away from the first storage array, and is located at a same height layer as the first redundant array. A spacing between the third redundant array and the first redundant array may be less than the sixth threshold, that is, may be similar to the spacing between the first redundant array and the first storage array. The third redundant array may be similar to the first redundant array, and details are not described herein again.

Optionally, the memory 100 may further include a fourth redundant array. The fourth redundant array may be located on a side that is of the second redundant array and that is away from the first storage array, and is located at a same height layer as the second redundant array. A spacing between the fourth redundant array and the second redundant array may be less than the sixth threshold, that is, may be similar to the spacing between the second redundant array and the first storage array. The fourth redundant array is similar to the second redundant array, and details are not described herein again.

Optionally, the memory 100 may further include a fifth redundant array. The fifth redundant array may be located at an upper end of the first storage array, and is located at a same height layer as the first storage array. The fifth redundant array and the first storage array may jointly form an mTnC structure. For example, assuming that the first storage array includes only an mT structure, the fifth redundant array may be an nC structure, and the fifth redundant array may be located at the upper end of the first storage array, and is connected to the mT structure of the first storage array, to form the mTnC structure. When the fifth redundant array is of the nC structure, the fifth redundant array may include n capacitor units, where n is a positive integer greater than or equal to 1. Each of the n capacitor units is similar to the ferroelectric capacitor unit 250 in FIG. 2, or each of the n capacitor units is similar to the ferroelectric capacitor unit in FIG. 3.

Optionally, the memory 100 may further include a sixth redundant array. The sixth redundant array may be located at a lower end of the first storage array, and is located at a same height layer as the first storage array. The sixth redundant array and the first storage array may jointly form an mTnC structure. For example, assuming that the first storage array includes only an nC structure, the sixth redundant array may be of a 1T structure, and the sixth redundant array may be located at a lower end of the first storage array, and is connected to the nC structure of the first storage array, to form the mTnC structure. When the sixth redundant array is of the 1T structure, the sixth redundant array may include one transistor. The transistor is similar to the back end vertical transistor 230 in FIG. 2, or is similar to the back end vertical transistor in FIG. 3.

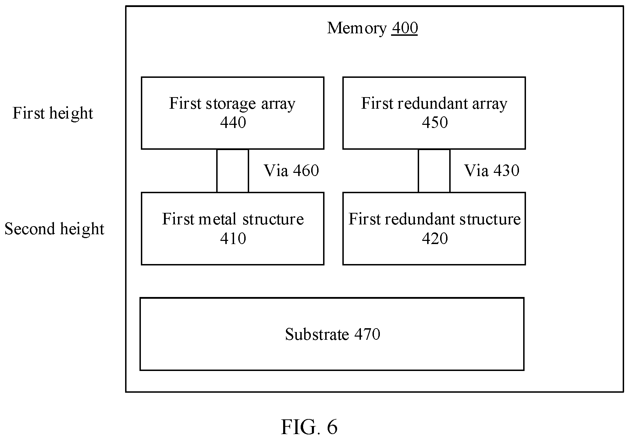

Optionally, a first metal structure and a first redundant structure may be further disposed in the memory 300. A first via may be further disposed in the memory 300, and the first via may be connected to the first redundant array and the first redundant structure. For details, refer to the descriptions in FIG. 6.

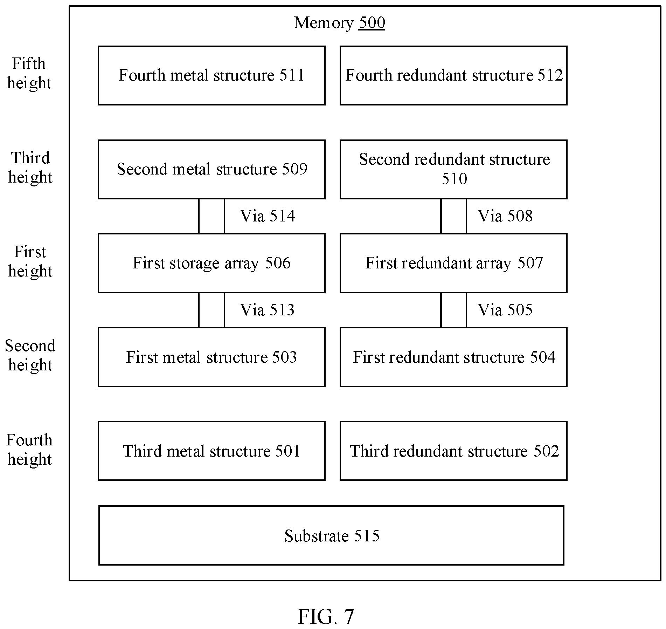

Optionally, a second metal structure and a second redundant structure may be further disposed in the memory 300. A second via may be further disposed in the memory 300, and the second via may be connected to the first redundant array and the second redundant structure. For details, refer to the descriptions in FIG. 7.

In the memory 300 shown in FIG. 5, the first redundant array 320 having the same layered structure or stacked structure as the first storage array 310 may be disposed at a same height layer of the first storage array 310, so that a structure of the layer can be even, excessive etching of metal in the CMP process can be avoided, and smoothness of the layer can be increased. The memory 300 shown in FIG. 5 may further enable ambient environments of the edge part and the central part of the first storage array 310 to be consistent, to avoid the deviation of the critical dimension of the first storage array in the photolithography process.

FIG. 6 is a diagram of a structure of a memory 400 according to an embodiment of this application. The memory 400 in FIG. 6 includes a first metal structure 410, a first redundant structure 420, a first via 430, a first storage array 440, a first redundant array 450, a via 460, and a substrate 470.

The substrate 470 is disposed at a lowest height layer of a structure other than the substrate 470 shown in FIG. 6, that is, the substrate 470 is lower than a first height. The first height may be a height between a first height layer and the substrate 470. The height is an interval instead of a specific value.

The first metal structure 410 may be a metal conducting wire, and may be configured to conduct electricity. A height of the first metal structure 410 relative to the substrate 470 is a second height, that is, the first metal structure 410 is located at a second height layer, and the second height layer is disposed in a direction in which the first height layer faces the substrate 470. In other words, the second height layer is lower than the first height layer at which the first storage array 440 and the first redundant array 450 are located, and the second height layer is higher than the substrate 470. A height of the second height layer may be a height between the second height layer and the substrate 470. The height is an interval instead of a specific value.

The first metal structure 410 may be similar to any one of the M1 to the M4 in FIG. 1.

Optionally, the first metal structure 410 may be electrically connected to an external circuit outside the memory. Alternatively, the first metal structure 410 may be located in a closed circuit, that is, a circuit in which the first metal structure 410 is located is a closed circuit. Alternatively, the first metal structure 410 cannot be in an open circuit, that is, the circuit in which the first metal structure 410 is located cannot be an open circuit.

Heights of the first redundant structure 420 and the first metal structure 410 relative to the substrate 470 are the same, that is, the first redundant structure 420 and the first metal structure 410 are located at a same height layer. In other words, the first redundant structure 420 is located at the second height layer.

Optionally, the first redundant structure 420 may be a metal block or a metal sheet, or the first redundant structure 420 may be a metal conducting wire. The first redundant structure 420 cannot be electrically connected to an external circuit outside the memory or a circuit in the memory. Alternatively, the first redundant structure 420 cannot be located in a closed circuit, that is, a circuit in which the first redundant structure 420 is located is not a closed circuit. Alternatively, the first redundant structure 420 may be in an open circuit, that is, the circuit in which the first redundant structure 420 is located is an open circuit.

A material of the first redundant structure 420 is the same as or similar to a material of the first metal structure 410. For example, assuming that the first metal structure 410 is the metal conducting wire, the first redundant structure 420 may be a metal block or metal sheet whose density is the same as or similar to that of the first metal structure. The first redundant structure 420 may be similar to any one of the DM1 to the DM4 in FIG. 1.

A size of the first redundant structure 420 in the second dimension is the same as or similar to a size of the first metal structure 410 in the second dimension. For example, the size of the first redundant structure 420 in the second dimension may be the same as the size of the first metal structure 410 in the second dimension. Alternatively, an absolute value of a difference between the size of the first redundant structure 420 in the second dimension and the size of the first metal structure 410 in the second dimension may be less than a second threshold, and the second threshold is a non-negative number.

When the first metal structure is the metal conducting wire, a size of the first metal structure in the second dimension may be a width of the metal conducting wire or the like.

For example, that the size of the first redundant structure 420 in the second dimension is the same as the size of the first metal structure 410 in the second dimension may include: A width of the first redundant structure 420 is the same as a width of the first metal structure 410.

For example, that the absolute value of the difference between the size of the first redundant structure 420 in the second dimension and the size of the first metal structure 410 in the second dimension is less than the second threshold may include: A difference between the size of the first redundant structure 420 in the second dimension and the size of the first metal structure 410 in the second dimension may be less than the second threshold, or a difference between the size of the first metal structure 410 in the second dimension and the size of the first redundant structure 420 in the second dimension may be less than the second threshold. This is not limited in this embodiment of this application.

For example, that the difference between the size of the first redundant structure 420 in the second dimension and the size of the first metal structure 410 in the second dimension is less than the second threshold may include: A difference between the width of the first redundant structure 420 and the width of the first metal structure 410 may be less than the second threshold. This is not limited in this embodiment of this application.

A relationship between the second threshold and the difference between the size of the first metal structure 410 in the second dimension and the size of the first redundant structure 420 in the second dimension is similar to that described above. Details are not described herein again.

Second thresholds may be the same or may be different based on different actual requirements or different CMP processes. This is not limited in this embodiment of this application. For example, if the difference between the width of the first redundant structure 420 and the width of the first metal structure 410 is less than the second threshold, the second threshold may be 90 nanometers (nanometer, nm).

If the second threshold is large, the difference between the size of the first redundant structure 420 in the second dimension and the size of the first metal structure 410 in the second dimension is large, so that a structure of the layer is uneven. Therefore, smoothness of the layer is low after the CMP process. If the second threshold is small, the difference between the size of the first redundant structure 420 in the second dimension and the size of the first metal structure 410 in the second dimension is small, so that a structure of the layer can be even, but a long time may be required in a process.

The first via 430 is configured to connect the first redundant structure 420 and the first redundant array 450. The first via 430 includes a conductive material, and the first via 430 is configured to conduct electricity between the first redundant structure 420 and the first redundant array 450, so that plasma generated in a process of preparing the memory 400 can be transmitted, to avoid a failure of a back end device, and improve reliability of the back end device.

Optionally, the first via 430 cannot be electrically connected to an external circuit outside the memory or a circuit in the memory. Alternatively, the first via 430 cannot be located in a closed circuit, that is, a circuit in which the first via 430 is located is not a closed circuit. Alternatively, the first via 430 may be in an open circuit, that is, a circuit in which the first via 430 is located is an open circuit. Although the first redundant array 450 has a same stacked structure as the first storage array 440, the first redundant structure 420, the first via 430, and the first redundant array 450 cannot be electrically connected to an external circuit outside the memory. Therefore, the first redundant array 450 cannot be configured to store data, that is, has no substantive function like data storage.

The first storage array 440 is similar to the first storage array 310 in FIG. 5, and details are not described herein again.

The first redundant array 450 is similar to the first redundant array 320 in FIG. 5, and details are not described herein again.

The via 460 is located between the first height layer and the second height layer, and may be configured to connect the first metal structure 410 and the first storage array 440. The via 460 may be further configured to conduct electricity. The via 460 is similar to the via CONT1 in FIG. 1.

The via 460 may be electrically connected to an external circuit outside the memory. Alternatively, the via 460 may be located in a closed circuit, that is, a circuit in which the via 460 is located is a closed circuit. Alternatively, the via 460 cannot be in an open circuit, that is, a circuit in which the via 460 is located cannot be an open circuit. Because the first metal structure 410, the first storage array 440, and the via 460 may be electrically connected to the external circuit outside the memory, the first storage array 440 may be configured to store data, that is, has a substantive function like data storage.

The substrate 470 is disposed in a direction in which the first metal structure 410 is away from the first storage array 440. The substrate 470 may be similar to the front end of line FEOL in FIG. 1.

The memory 400 shown in FIG. 6 may enable an ambient environment of an edge part of the first storage array to be consistent with an ambient environment of a central part of the first storage array, to avoid a deviation caused by optical reflection or diffraction. The first redundant array and the first redundant structure may be added to the memory 400 shown in FIG. 6, so that a structure of a layer at which the storage array or the metal structure is located in the memory is even, to avoid a phenomenon of metal layer dishing or dielectric layer erosion, and improve smoothness of the layer. The memory 400 shown in FIG. 6 may further provide, through the first via, a discharge channel for the plasma generated in a process, to avoid damage to the back end device.

FIG. 7 is a diagram of a structure of a memory 500 according to an embodiment of this application. The memory 500 in FIG. 7 includes a third metal structure 501, a third redundant structure 502, a first metal structure 503, a first redundant structure 504, a first storage array 506, a first redundant array 507, a second metal structure 509, a second redundant structure 510, a fourth metal structure 511, a fourth redundant structure 512, a via 513, a via 514, and a substrate 515.

The first redundant array 507 is connected to the first redundant structure 504 through a first via 505, and the first redundant array 507 is connected to the second redundant structure 510 through a second via 508. The substrate 515 is disposed at a lowest height layer of a structure other than the substrate 515 shown in FIG. 7, that is, the substrate 515 is lower than a first height. The substrate 515 may be similar to a front end of line FEOL in FIG. 1, or may be similar to a substrate 470 in FIG. 6. Details are not described herein again. The first height may be a height of a first height layer relative to the substrate 515.

The first storage array 506 and the first redundant array 507 are located at the first height layer. The first storage array 506 is similar to the first storage array 310 in FIG. 5, and details are not described herein again. The first redundant array 507 is similar to the first redundant array 320 in FIG. 5, and details are not described herein again.

Heights of the third metal structure 501 and the third redundant structure 502 relative to the substrate 515 are the same. The heights of the third metal structure 501 and the third redundant structure 502 relative to the substrate 515 are a fourth height, that is, the third metal structure 501 and the third redundant structure 502 are located at a fourth height layer, and the fourth height layer is disposed in a direction in which the first height layer faces the substrate. In other words, the fourth height layer is lower than the first height layer at which the first storage array 506 and the first redundant array 507 are located, and the fourth height layer is higher than the substrate 515. A height of the fourth height layer may be a height between the fourth height layer and the substrate 515. The height is an interval instead of a specific value.

Optionally, the third metal structure 501 may be electrically connected to an external circuit outside the memory. Alternatively, the third metal structure 501 may be located in a closed circuit, that is, a circuit in which the third metal structure 501 is located is a closed circuit. Alternatively, the third metal structure 501 cannot be in an open circuit, that is, the circuit in which the third metal structure 501 is located cannot be an open circuit.

Optionally, the third redundant structure 502 cannot be electrically connected to an external circuit outside the memory or a circuit in the memory. Alternatively, the third redundant structure 502 cannot be located in a closed circuit, that is, a circuit in which the third redundant structure 502 is located is not a closed circuit. Alternatively, the third redundant structure 502 may be in an open circuit, that is, the circuit in which the third redundant structure 502 is located is an open circuit.

A difference between a size of the third metal structure 501 in a fourth dimension and a size of the third redundant structure 502 in the fourth dimension is less than a fourth threshold. The third metal structure 501 is similar to the first metal structure 410 in FIG. 6, and details are not described herein again. The third redundant structure 502 is similar to the first redundant structure 420 in FIG. 6, and details are not described herein again. The size of the third metal structure 501 in the fourth dimension is similar to a size of the first metal structure 410 in a second dimension. Details are not described herein again.

The first metal structure 503 and the first redundant structure 504 are located at a second height layer. The second height layer is disposed between the first height layer and the fourth height layer, that is, the second height layer is lower than the first height layer at which the first storage array 506 and the first redundant array 507 are located, and the second height layer is higher than the fourth height layer at which the third metal structure 501 and the third redundant structure 502 are located. A height of the second height layer may be a height between the second height layer and the substrate 515.

The first metal structure 503 is similar to the first metal structure 410 in FIG. 6, and details are not described herein again. The first redundant structure 504 is similar to the first redundant structure 420 in FIG. 6, and details are not described herein again.

The via 513 is located between the first height layer and the second height layer, and the via 513 may be configured to conduct electricity. The via 513 is similar to the via CONT1 in FIG. 1, or may be similar to the via 460 in FIG. 6.

The first via 505 is configured to connect the first redundant array 507 and the first redundant structure 504. The first via 505 is similar to the first via 430 in FIG. 6, and details are not described herein again.

Heights of the second metal structure 509 and the second redundant structure 510 relative to the substrate 515 are the same. The heights of the second metal structure 509 and the second redundant structure 510 relative to the substrate 515 are a third height, that is, the second metal structure 509 and the second redundant structure 510 are located at a third height layer, and the third height layer is disposed in a direction in which the first height layer is away from the substrate. In other words, the third height layer is higher than the first height layer at which the first storage array 506 and the first redundant array 507 are located. A height of the third height layer may be a height between the third height layer and the substrate 515. The height is an interval instead of a specific value.

The second metal structure 509 may be a metal conducting wire, and may be configured to conduct electricity. The second metal structure 509 may be similar to the metal structures M5 to M8 in FIG. 1.

Optionally, the second metal structure 509 may be electrically connected to an external circuit outside the memory. Alternatively, the second metal structure 509 may be located in a closed circuit, that is, a circuit in which the second metal structure 509 is located is a closed circuit. Alternatively, the second metal structure 509 cannot be in an open circuit, that is, the circuit in which the second metal structure 509 is located cannot be an open circuit.

Optionally, the second redundant structure 510 may be a metal block or a metal sheet, or may be a metal conducting wire. The second redundant structure 510 cannot be electrically connected to an external circuit outside the memory or a circuit in the memory. Alternatively, the second redundant structure 510 cannot be located in a closed circuit, that is, a circuit in which the second redundant structure 510 is located is not a closed circuit. Alternatively, the second redundant structure 510 may be in an open circuit, that is, the circuit in which the second redundant structure 510 is located is an open circuit.

A material of the second redundant structure 510 is the same as or similar to a material of the second metal structure 509. For example, assuming that the second metal structure 509 is a metal conducting wire, the second redundant structure 510 is a metal block or metal sheet whose density is the same as or similar to that of the second metal structure. The second redundant structure 510 may be similar to the redundant structures DM5 to DM8 in FIG. 1.

A size of the second redundant structure 510 in a third dimension is the same as or similar to a size of the second metal structure 509 in the third dimension. For example, the size of the second redundant structure 510 in the third dimension may be the same as the size of the second metal structure 509 in the third dimension. Alternatively, an absolute value of a difference between the size of the second redundant structure 510 in the third dimension and the size of the second metal structure 509 in the third dimension may be less than a third threshold, and the third threshold is a non-negative number.

When the second metal structure 509 is a metal conducting wire, the size of the second metal structure 509 in the third dimension may be a width of the metal conducting wire or the like.

For example, that the size of the second redundant structure 510 in the third dimension is the same as the size of the second metal structure 509 in the third dimension may include: A width of the second redundant structure 510 is the same as the width of the second metal structure 509.

For example, that the absolute value of the difference between the size of the second redundant structure 510 in the third dimension and the size of the second metal structure 509 in the third dimension is less than the third threshold may include: A difference between the size of the second redundant structure 510 in the third dimension and the size of the second metal structure 509 in the third dimension may be less than the third threshold, or a difference between the size of the second metal structure 509 in the third dimension and the size of the second redundant structure 510 in the third dimension may be less than the third threshold. This is not limited in this embodiment of this application.

For example, that the difference between the size of the second redundant structure 510 in the third dimension and the size of the second metal structure 509 in the third dimension is less than the third threshold may include: A difference between the width of the second redundant structure 510 and the width of the second metal structure 509 may be less than the third threshold. This is not limited in this embodiment of this application.

A relationship between the third threshold and the difference between the size of the second metal structure 509 in the third dimension and the size of the second redundant structure 510 in the third dimension is similar to that described above. Details are not described herein again.

Third thresholds may be the same or may be different based on different actual requirements or different CMP processes. This is not limited in this embodiment of this application. For example, if the difference between the width of the second redundant structure 510 and the width of the second metal structure 509 is less than the third threshold, the third threshold may be 100 nanometers (nanometer, nm).

If the third threshold is large, the difference between the size of the second redundant structure 510 in the third dimension and the size of the second metal structure 509 in the third dimension is large, so that a structure of the layer is uneven. Therefore, smoothness of the layer is low after the CMP process. If the third threshold is small, the difference between the size of the second redundant structure 510 in the third dimension and the size of the second metal structure 509 in the third dimension is small, so that the structure of the layer can be even, but a long time may be required in a process.

The via 514 is located between the first height layer and the third height layer, and the via 514 may be configured to conduct electricity. The via 514 is similar to the via CONT2 in FIG. 1.

Optionally, the via 514 may be electrically connected to an external circuit outside the memory. Alternatively, the via 514 may be located in a closed circuit, that is, a circuit in which the via 514 is located is a closed circuit. Alternatively, the via 514 cannot be in an open circuit, that is, a circuit in which the via 514 is located cannot be an open circuit. Because the first metal structure 503, the via 513, the first storage array 506, the via 514, and the second metal structure 509 may be electrically connected to the external circuit outside the memory, the first storage array 506 may store data, that is, has a substantive function like data storage.

The second via 508 is configured to connect the first redundant array 507 and the second redundant structure 510. The second via includes a conductive material, and the second via is configured to conduct electricity between the first redundant array 507 and the second redundant structure 510, so that plasma generated in a process of preparing the memory 500 can be transmitted, to avoid a failure of a back end device.

Optionally, the second via 508 cannot be electrically connected to an external circuit outside the memory or a circuit in the memory. Alternatively, the second via 508 cannot be located in a closed circuit, that is, a circuit in which the second via 508 is located is not a closed circuit. Alternatively, the second via 508 may be in an open circuit, that is, a circuit in which the second via 508 is located is an open circuit. Although the first redundant array 507 has a same stacked structure as the first storage array 506, the first redundant structure 504, the first via 505, the first redundant array 507, the second via 508, and the second redundant structure 510 cannot be electrically connected to an external circuit outside the memory. Therefore, the first redundant array 507 cannot be configured to store data, that is, has no substantive function like data storage.

Heights of the fourth metal structure 511 and the fourth redundant structure 512 relative to the substrate 515 are the same. The heights of the fourth metal structure 511 and the fourth redundant structure 512 relative to the substrate 515 are a fifth height. In other words, the fourth metal structure 511 and the fourth redundant structure 512 are located at a fifth height layer, and the fifth height layer is disposed in a direction in which the third height layer is away from the substrate. In other words, the fifth height layer is higher than the third height layer at which the second metal structure 509 and the second redundant structure 510 are located. A height of the fifth height layer may be a height between the fifth height layer and the substrate 515. The height is an interval instead of a specific value.

A difference between a size of the fourth metal structure in a fifth dimension and a size of the fourth redundant structure in the fifth dimension is less than a fifth threshold. The fourth metal structure 511 is similar to the second metal structure 509, and details are not described herein again. The fourth redundant structure 512 is similar to the second redundant structure 510, and details are not described herein again. The size of the fourth metal structure in the fifth dimension is similar to the size of the second metal structure 509 in the third dimension. Details are not described herein again.

Optionally, the fourth metal structure 511 may be a metal conducting wire. The fourth metal structure 511 may be electrically connected to the external circuit outside the memory. Alternatively, the fourth metal structure 511 may be located in a closed circuit, that is, a circuit in which the fourth metal structure 511 is located is a closed circuit. Alternatively, the fourth metal structure 511 cannot be in an open circuit, that is, the circuit in which the fourth metal structure 511 is located cannot be an open circuit.

Optionally, the fourth redundant structure 512 may be a metal block or a metal sheet, or may be a metal conducting wire. The fourth redundant structure 512 cannot be electrically connected to the external circuit outside the memory or the circuit in the memory. Alternatively, the fourth redundant structure 512 cannot be located in a closed circuit, that is, a circuit in which the fourth redundant structure 512 is located is not a closed circuit. Alternatively, the fourth redundant structure 512 may be in an open circuit, that is, the circuit in which the fourth redundant structure 512 is located is an open circuit.

Optionally, the memory 500 may include one or more first metal structures and one or more first redundant structures, and the one or more first metal structures are in a one-to-one correspondence with the one or more first redundant structures. Each of the one or more first redundant structures is located at a same layer as a first metal structure corresponding to the first redundant structure. Each of the one or more first redundant structures is disposed in a direction in which the first height layer faces the substrate 515, that is, each first redundant structure is lower than the first height layer at which the first redundant array is located.

Alternatively, the memory 500 may include one or more third metal structures and one or more third redundant structures, and the one or more third metal structures are in a one-to-one correspondence with the one or more third redundant structures. Each of the one or more third redundant structures and a third metal structure corresponding to the third redundant structure are located at a same layer. Each of the one or more third redundant structures is disposed in a direction in which the first height layer faces the substrate 515, that is, each third redundant structure is lower than the first height layer at which the first redundant array is located.

Optionally, the memory 500 may include one or more second metal structures and one or more second redundant structures, and the one or more second metal structures are in a one-to-one correspondence with the one or more second redundant structures. Each of the one or more second redundant structures is located at a same layer as a second metal structure corresponding to the second redundant structure. Each of the one or more second redundant structures is disposed in a direction in which the first height layer is away from the substrate 515, that is, each second redundant structure is higher than the first height layer at which the first redundant array is located.

Alternatively, the memory 500 may include one or more fourth metal structures and one or more fourth redundant structures, and the one or more fourth metal structures are in a one-to-one correspondence with the one or more fourth redundant structures. Each of the one or more fourth redundant structures and a fourth metal structure corresponding to the fourth redundant structure are located at a same layer. Each of the one or more fourth redundant structures is disposed in a direction in which the first height layer is away from the substrate 515, that is, each fourth redundant structure is higher than the first height layer at which the first redundant array is located.

Optionally, the memory 500 may further include at least one third via or at least one fourth via. Each of the at least one third via and each of the at least one fourth via may be configured to transmit the plasma generated in a process of preparing the memory 500, to avoid a failure of the back end device, and improve reliability of the back end device.

Optionally, the third via may be configured to connect a first redundant structure and a third redundant structure that are adjacent to each other, some or all areas of the first redundant structure and the third redundant structure overlap in a vertical direction, and a spacing between the first redundant structure and the third redundant structure is less than a seventh threshold.

For example, the memory 500 may further include a third via that connects the first redundant structure 504 and the third redundant structure 502 that are adjacent to each other, some or all areas of the first redundant structure 504 and the third redundant structure 502 overlap in the vertical direction, and a spacing between the first redundant structure 504 and the third redundant structure 502 is less than the seventh threshold.

Optionally, the fourth via may be configured to connect a second redundant structure and a fourth redundant structure that are adjacent to each other, some or all areas of the second redundant structure and the fourth redundant structure overlap in the vertical direction, and a spacing between the second redundant structure and the fourth redundant structure is less than an eighth threshold.

For example, the memory 500 may further include the fourth via that connects the second redundant structure 510 and the fourth redundant structure 512 that are adjacent to each other, some or all areas of the second redundant structure 510 and the fourth redundant structure 512 overlap in the vertical direction, and the spacing between the second redundant structure 510 and the fourth redundant structure 512 is less than the eighth threshold.

When the memory 500 includes at least two first redundant structures, the memory 500 further includes a third via configured to connect two adjacent first redundant structures in the at least two first redundant structures. Some or all areas of the two adjacent first redundant structures overlap in the vertical direction, and a spacing between the two adjacent first redundant structures is less than the seventh threshold.

Alternatively, when the memory 500 includes at least two third redundant structures, the memory 500 further includes a third via configured to connect two adjacent third redundant structures in the at least two third redundant structures. Some or all areas of the two adjacent third redundant structures overlap in the vertical direction, and a spacing between the two adjacent third redundant structures is less than the seventh threshold.

Seventh thresholds may be the same or may be different based on different actual requirements or different CMP processes. This is not limited in this embodiment of this application. For example, a value range of the seventh threshold is approximately 90 nanometers to 120 nanometers.

If the seventh threshold is large, a spacing between two redundant structures connected to the third via is large, process difficulty is high, and the two redundant structures are easily disconnected. If the seventh threshold is small, a spacing between two redundant structures connected to the third via is small, and process difficulty is low. However, an electric leakage problem is likely to occur, and consequently the device is unstable.

When the memory 500 includes at least two second redundant structures, the memory 500 further includes a fourth via configured to connect two adjacent second redundant structures in the at least two second redundant structures. Some or all areas of the two adjacent second redundant structures overlap in the vertical direction, and a spacing between the two adjacent second redundant structures is less than the eighth threshold.

When the memory 500 includes the at least two fourth redundant structures, the memory 500 further includes a fourth via configured to connect two adjacent fourth redundant structures in the at least two fourth redundant structures. Some or all areas of the two adjacent fourth redundant structures overlap in the vertical direction, and a spacing between the two adjacent fourth redundant structures is less than the eighth threshold.

Eighth thresholds may be the same or may be different based on different actual requirements or different CMP processes. This is not limited in this embodiment of this application. For example, a value range of the eighth threshold may be 200 nanometers to 400 nanometers.

If the eighth threshold is large, a spacing between two redundant structures connected to the fourth via is large, process difficulty is high, and the two redundant structures are easily disconnected. If the eighth threshold is small, a spacing between two second redundant structures connected to the fourth via is small, and process difficulty is low. However, a leakage problem is likely to occur, and consequently the device is unstable.

Optionally, the memory 500 may further include a fifth via. The fifth via may be configured to transmit the plasma generated in a process of preparing the memory 500, to avoid a failure of the back end device, and improve reliability of the back end device.

Optionally, the fifth via may be configured to connect the first redundant structure and the second redundant structure that are adjacent to each other. Some or all areas of the first redundant structure and the second redundant structure that are adjacent to each other overlap in the vertical direction, and a spacing between the first redundant structure and the second redundant structure is less than a ninth threshold.

For example, when the memory 500 does not include the first storage array 506 or the first redundant array 507 located between the first redundant structure 504 and the second redundant structure 510, the memory 500 further includes the fifth via that connects the first redundant structure 504 and the second redundant structure 510 that are adjacent to each other. Some or all areas of the first redundant structure 504 and the second redundant structure 510 that are adjacent to each other overlap, and a spacing between the first redundant structure 504 and the second redundant structure 510 is less than the ninth threshold.

Ninth thresholds may be the same or may be different based on different actual requirements or different CMP processes. This is not limited in this embodiment of this application. For example, a value range of the ninth threshold may be 100 nanometers to 300 nanometers.

If the ninth threshold is large, the spacing between the first redundant structure and the second redundant structure that are adjacent to each other is large, process difficulty is high, and the two redundant structures are easily disconnected. If the ninth threshold is small, the spacing between the first redundant structure and the second redundant structure that are adjacent to each other is small, and process difficulty is low. However, a leakage problem is likely to occur, and consequently the device is unstable.

The memory 500 shown in FIG. 7 may enable ambient environments of an edge part and a central part of the first storage array to be consistent, to avoid a deviation caused in a photolithography process. The memory 500 shown in FIG. 7 may further improve evenness of a structure in each height layer by adding the first redundant array, the first redundant structure, and the second redundant structure, to increase smoothness of the layer after the CMP process. The memory 500 shown in FIG. 7 may further release, through the first via and the second via, the plasma generated in the process, to improve reliability of the back end device.

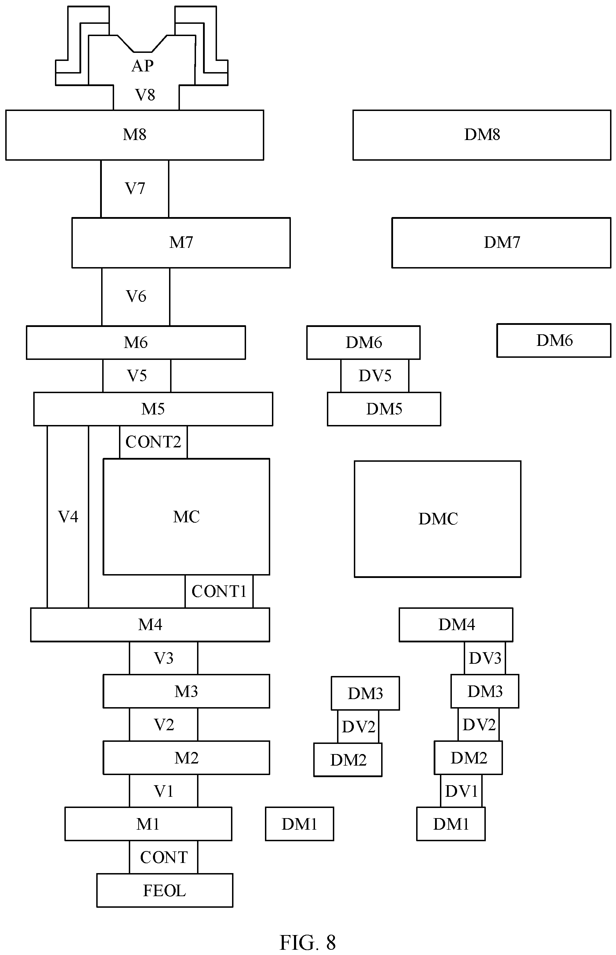

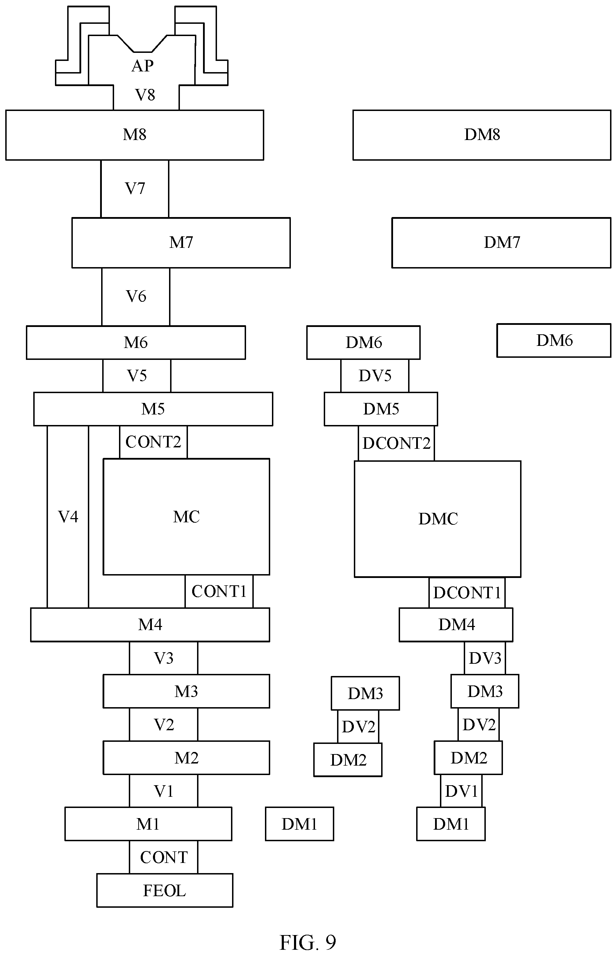

In an actual industrial manufacturing process, schematic cross-sectional views of the memory in embodiments of this application are shown in FIG. 8 and FIG. 9.

FIG. 8 is a schematic cross-sectional view of a memory after a redundant array is added. FIG. 8 includes all structures except the redundant structure DM0 shown in FIG. 1. FIG. 8 further includes a redundant array DMC.

Heights of the redundant array DMC and a storage array MC relative to the front end of line FEOL are the same, that is, the redundant array DMC and the storage array MC are located at a same height layer. The DMC is similar to the first redundant array in FIG. 5 to FIG. 7, that is, the DMC has a same stacked structure as the storage array MC. In an actual manufacturing process, a height layer at which the DMC is located is higher than a height layer at which a redundant structure DM4 is located.

Because the redundant array DMC and the storage array MC in FIG. 8 have a same stacked structure, an environment difference between an edge part and a central part of the storage array MC is small. In a photolithography process, a deviation of a critical dimension of the storage array MC is small. In addition, because structures of height layers at which the redundant arrays DMC in FIG. 8 are located are evenly distributed, in a CMP process, serious metal layer dishing or dielectric layer erosion is not likely to occur at the layers.

FIG. 9 is a schematic cross-sectional view of a memory after a via is added. FIG. 9 includes all structures shown in FIG. 8, and FIG. 9 further includes a via DCONT1 and a via DCONT2.

The via DCONT1 is disposed between the redundant structure DM4 and the redundant array DMC, and heights of the DCONT1 and the CONT 1 relative to the FEOL are the same, that is, the DCONT1 and the CONT1 are located at a same height layer. The DCONT1 is disposed in a direction in which the DM4 faces the redundant array DMC. In an actual manufacturing process, the height layer at which the DCONT1 is located is higher than a height layer at which the DM4 is located. The DCONT1 is similar to the first via 430 in FIG. 6, or is similar to the first via 505 in FIG. 7.

The via DCONT2 is disposed between the redundant structure DM5 and the redundant array DMC, and heights of the DCONT2 and the CONT2 relative to the FEOL are the same, that is, the DCONT2 and the CONT2 are located at a same height layer. The DCONT2 is disposed in a direction in which the DM5 faces the redundant array DMC. In an actual manufacturing process, the height layer at which the DCONT2 is located is higher than the height layer at which the redundant array DMC is located. The DCONT2 is similar to the second via 508 in FIG. 7.

In the memory in FIG. 9, the via DCONT1 that connects the redundant structure DM4 and the redundant array DMC and the via DCONT2 that connects the redundant structure DM5 and the DMC are added, to release plasma generated in a process, and avoid damage to the device.

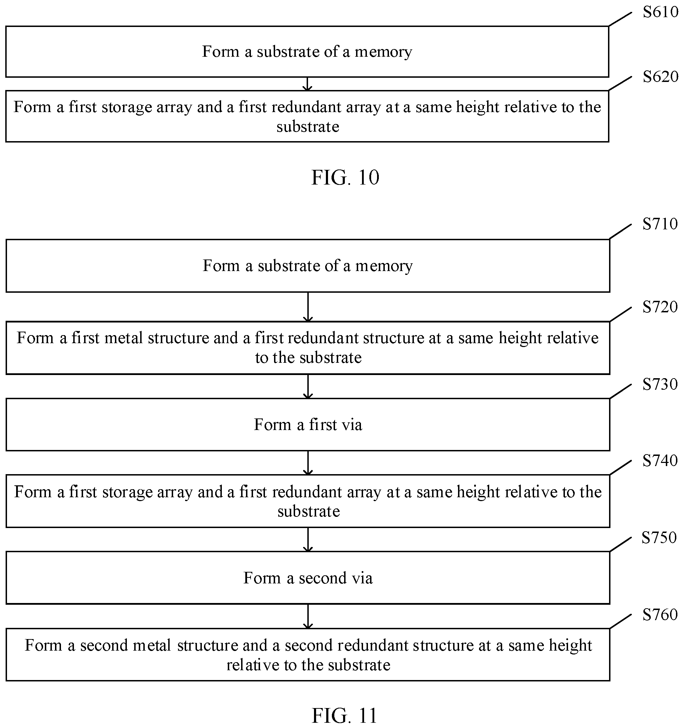

FIG. 10 shows a memory preparation method. The method shown in FIG. 10 includes the following steps.

S610: Form a substrate of a memory.

Optionally, the substrate of the memory may be disposed at a lowest height layer, that is, the substrate may be lower than a first height. The first height is heights of a first storage array and a first redundant array relative to the substrate.

Optionally, the substrate may be a substrate in various forms, for example, may be a silicon substrate, a bulk semiconductor material substrate, a semiconductor-on-insulator substrate, or a compound semiconductor substrate. This is not limited in this embodiment of this application. The substrate may be similar to the front end of line FEOL in FIG. 1, the substrate 330 in FIG. 5, the substrate 470 in FIG. 6, or the substrate 515 in FIG. 7.

S620: Form the first storage array and the first redundant array at a same height relative to the substrate.

The first storage array and the first redundant array are formed at the same height relative to the substrate. The heights of the first storage array and the first redundant array relative to the substrate may be the first height. The first height is an interval instead of a specific value. In other words, the first redundant array and the first storage array may be disposed at a same height layer, for example, a first height layer, as shown in the memory 300 in FIG. 5.

The first storage array includes a stacked structure including at least one transistor and at least one capacitor unit, and the first storage array may be configured to store data.

The first redundant array includes a stacked structure including at least one transistor and at least one capacitor unit, and the first redundant array and the first storage array have a same stacked structure. A size of the first redundant array in a first dimension is similar to or the same as a size of the first storage array in the first dimension. The first redundant array may be similar to the first redundant array 320 shown in FIG. 5, and the first storage array may be similar to the first storage array 310 shown in FIG. 5.

Optionally, each of the stacked structures of the first storage array and the first redundant array may include an mTnC structure. The mTnC structure includes m transistors and n capacitor units that are stacked, and m and n are positive integers greater than or equal to 1.

Optionally, the forming the first storage array and the first redundant array at a same height relative to the substrate includes: forming the at least one transistor of the first storage array and the at least one transistor of the first redundant array at a same layer of the first storage array and the first redundant array; and forming the at least one capacitor unit of the first storage array and the at least one capacitor unit of the first redundant array at a same layer of the first storage array and the first redundant array. The same layer is a same wiring layer or a same multi-layer wiring layer. This is not limited in this embodiment of this application.

Optionally, each of the stacked structures of the first storage array and the first redundant array may further include at least one of the following structures: a word line, a bit line, a plate line plane, or a pillar. Any one of the at least one transistor is connected to the word line, the bit line, or the pillar. Alternatively, any one of the at least one capacitor unit is disposed at an intersection point between the plate line plane and the pillar.

It should be understood that, on a basis that the first redundant array has the same stacked structure as the first storage array, the first redundant array may have electronic components completely the same as those of the first storage array, or may have some electronic components same as those of the first storage array.

Optionally, the first storage array is electrically connected to an external circuit outside the memory, and the first redundant array is disposed in an open circuit or is not electrically connected to a circuit in the memory. Alternatively, the first storage array may be disposed in a closed circuit, and the first redundant array cannot be electrically connected to an external circuit outside the memory or a circuit in the memory.

Optionally, a sequence of forming the first storage array and the first redundant array in the first height layer of the memory is not limited in this embodiment of this application. For example, the first storage array may be first formed at the first height layer of the memory, and then the first redundant array is formed at the first height layer of the memory. Alternatively, the first redundant array may be first formed at the first height layer of the memory, and then the first storage array is formed at the first height layer of the memory. Alternatively, the first storage array and the first redundant array may be simultaneously formed at the first height layer of the memory.

Optionally, that the first storage array and the first redundant array are simultaneously formed at the first height layer includes: at least one electronic component of the first storage array and at least one electronic component corresponding to the first redundant array are simultaneously formed at the first height layer. For example, at least one word line of the first storage array and at least one word line corresponding to the first redundant array are simultaneously formed at the first height layer. Alternatively, at least one bit line of the first storage array, at least one bit line corresponding to the first redundant array, and the like are simultaneously formed at the first height layer.

According to the memory preparation method in FIG. 10, the first redundant array with the same stacked structure may be added to a same height layer of the first storage array, so that an ambient environment of an edge part of the first storage array is consistent with an ambient environment of a central part of the first storage array, to avoid a deviation caused by a photolithography process. In addition, adding the first redundant array with the same stacked structure may further enable a structure of the height layer even, and increase smoothness of the layer after a CMP process.

FIG. 11 shows a memory preparation method. The method shown in FIG. 11 includes the following steps.

S710: Form a substrate of a memory. Step S710 is similar to step S610, and details are not described herein again.

S720: Form a first metal structure and a first redundant structure at a same height relative to the substrate.

Heights of the first metal structure and the first redundant structure relative to the substrate may be a second height, and the second height is an interval instead of a specific value. In other words, the first metal structure and the first redundant structure may be disposed at a second height layer.

The second height layer is disposed in a direction in which a first height layer faces the substrate of the memory, that is, the second height layer is lower than the first height layer of the memory. In the memory, a size of the first redundant structure at the second height layer in a second dimension is the same as or similar to a size of the first metal structure at the second height layer in the second dimension, and a material of the first redundant structure is the same as or similar to a material of the first metal structure. The first metal structure may be similar to the first metal structure 503 in FIG. 7, and details are not described herein again. The first redundant structure may be similar to the first redundant structure 504 in FIG. 7, and details are not described herein again.

Optionally, the first metal structure and the first redundant structure may be simultaneously formed at the second height layer.

Optionally, the first metal structure may be a metal conducting wire. The first metal structure may be electrically connected to an external circuit outside the memory. Alternatively, the first metal structure may be located in a closed circuit, that is, a circuit in which the first metal structure is located is a closed circuit. Alternatively, the first metal structure cannot be in an open circuit, that is, the circuit in which the first metal structure is located cannot be an open circuit.

Optionally, the first redundant structure may be a metal block or a metal sheet, or may be a metal conducting wire. The first redundant structure cannot be electrically connected to an external circuit outside the memory or a circuit in the memory. Alternatively, the first redundant structure cannot be located in a closed circuit, that is, a circuit in which the first redundant structure is located is not a closed circuit. Alternatively, the first redundant structure may be in an open circuit, that is, the circuit in which the first redundant structure is located is an open circuit.

Optionally, before the first metal structure and the first redundant structure are formed at the second height layer, a third metal structure and a third redundant structure may be further formed at a fourth height layer. The fourth height layer is disposed in a direction in which the second height layer faces the substrate, that is, the fourth height layer is lower than the second height layer of the memory, and the fourth height layer is higher than the substrate. A size of the third redundant structure in a fourth dimension is the same as or similar to a size of the third metal structure in the fourth dimension, and a material of the third redundant structure is the same as or similar to a material of the third metal structure. The third metal structure may be similar to the third metal structure 501 in FIG. 7, and details are not described herein again. The third redundant structure may be similar to the third redundant structure 502 in FIG. 7, and details are not described herein again.

Optionally, before the first metal structure and the first redundant structure are formed at the second height layer, a third via may be further formed. The third via is configured to connect the first redundant structure and the third redundant structure that are adjacent to each other. Some or all areas of the first redundant structure and the third redundant structure that are adjacent to each other overlap, and a spacing between the first redundant structure and the third redundant structure is less than a seventh threshold.

A sequence of forming the third via is as follows: The third metal structure and the third redundant structure are first formed at the fourth height layer; and then the third via is formed, where one side of the third via is connected to the third redundant structure. Then, the first metal structure and the first redundant structure are formed at the second height layer, and the first redundant structure is connected to the other side of the third via.

Optionally, a plurality of first redundant structures may be formed, and a third via may be formed between two adjacent first redundant structures. Some or all areas of the two adjacent first redundant structures overlap, and a spacing between the two first redundant structures is less than the seventh threshold. An implementation of forming the third via between the two adjacent first redundant structures is similar to the foregoing description, and details are not described herein again.

Alternatively, a plurality of third redundant structures may be formed, and a third via may be formed between two adjacent third redundant structures. Some or all areas of the two adjacent third redundant structures overlap, and a spacing between the two third redundant structures is less than the seventh threshold. An implementation of forming the third via between the two adjacent third redundant structures is similar to the foregoing description, and details are not described herein again.

S730: Form a first via.

After the first metal structure and the first redundant structure are formed at the same height relative to the substrate, the first via may be formed. The first via is configured to connect the first redundant structure and the first redundant array, that is, the first via may be disposed between the first height layer and the second height layer. The first via is similar to the first via 430 in FIG. 6, or is similar to the first via 505 in FIG. 7.

Optionally, the first via cannot be electrically connected to an external circuit outside the memory or a circuit in the memory. Alternatively, the first via cannot be located in a closed circuit, that is, a circuit in which the first via is located is not a closed circuit. Alternatively, the first via may be in an open circuit, that is, the circuit in which the first via is located is an open circuit.

S740: Form the first storage array and the first redundant array at the same height relative to the substrate.

After the first via is formed, the first storage array and the first redundant array may be formed at the same height relative to the substrate. The heights of the first storage array and the first redundant array relative to the substrate are a first height, that is, the first storage array and the first redundant array are located at the first height layer. The first height layer is disposed in a direction in which the second height layer is away from the substrate, that is, the first height layer is higher than the second height layer. The first redundant array is connected to the first via.

A specific implementation of forming the first storage array and the first redundant array at the same height relative to the substrate is similar to that in step S610. Details are not described herein again.

S750: Form a second via.

After the first storage array and the first redundant array are formed at the same height relative to the substrate, the second via may be formed. The second via is configured to connect the first redundant array and a second redundant structure, that is, the second via is located between the first height layer and a third height layer. The second via is similar to the second via 508 in FIG. 7.

Optionally, the second via cannot be electrically connected to an external circuit outside the memory or a circuit in the memory. Alternatively, the second via cannot be located in a closed circuit, that is, a circuit in which the second via is located is not a closed circuit. Alternatively, the second via may be in an open circuit, that is, the circuit in which the second via is located is an open circuit.

S760: Form a second metal structure and the second redundant structure at a same height relative to the substrate.

The heights of the second metal structure and the second redundant structure relative to the substrate may be a third height, that is, the second metal structure and the second redundant structure may be located at the third height layer. The third height layer is disposed in a direction in which the first height layer is away from the substrate, that is, the third height layer is higher than the first height layer. A size of the second redundant structure at the third height layer in a third dimension is the same as or similar to a size of the second metal structure at the third height layer in the third dimension, and a material of the second redundant structure is the same as or similar to a material of the second metal structure. The second metal structure may be similar to the second metal structure 509 in FIG. 7, and details are not described herein again. The second redundant structure may be similar to the second redundant structure 510 in FIG. 7, and details are not described herein again.

Optionally, the second metal structure and the second redundant structure may be simultaneously formed at the third height layer.

Optionally, the second metal structure may be a metal conducting wire. The second metal structure may be electrically connected to an external circuit outside the memory. Alternatively, the second metal structure may be located in a closed circuit, that is, a circuit in which the second metal structure is located is a closed circuit. Alternatively, the second metal structure cannot be in an open circuit, that is, the circuit in which the second metal structure is located cannot be an open circuit. Because the first metal structure, the first storage array, and the second metal structure may be electrically connected to an external circuit outside the memory, the first storage array 506 may store data, that is, has a substantive function like data storage.

Optionally, the second redundant structure may be a metal block or a metal sheet, or may be a metal conducting wire. The second redundant structure cannot be electrically connected to an external circuit outside the memory or a circuit in the memory. Alternatively, the second redundant structure cannot be located in a closed circuit, that is, a circuit in which the second redundant structure is located is not a closed circuit. Alternatively, the second redundant structure may be in an open circuit, that is, the circuit in which the second redundant structure is located is an open circuit. Although the first redundant array has the same stacked structure as the first storage array, because the first redundant structure, the first via, the first redundant array, the second via, and the second redundant structure cannot be electrically connected to an external circuit outside the memory, the first redundant array cannot be configured to store data, that is, has no substantive function like data storage.

Optionally, after the second metal structure and the second redundant structure are formed at the third height layer, a fourth metal structure and a fourth redundant structure may be further formed at a fifth height layer. The fifth height layer is disposed in a direction in which the third height layer is away from the substrate, that is, the fifth height layer is higher than the third height layer. A size of the fourth redundant structure at the fifth height layer in a fifth dimension is the same as or similar to a size of the fourth metal structure at the fifth height layer in the fifth dimension, and a material of the fourth redundant structure is the same as or similar to a material of the fourth metal structure. The fourth metal structure may be similar to the fourth metal structure 511 in FIG. 7, and details are not described herein again. The fourth redundant structure may be similar to the fourth redundant structure 512 in FIG. 7, and details are not described herein again.

Optionally, before the fourth metal structure and the fourth redundant structure are formed at the fifth height layer, a fourth via may be formed. The fourth via is configured to connect the second redundant structure and the fourth redundant structure that are adjacent to each other. Some or all areas of the second redundant structure and the fourth redundant structure that are adjacent to each other overlap, and a spacing between the second redundant structure and the fourth redundant structure is less than an eighth threshold.

A sequence of forming the fourth via is as follows: The second metal structure and the second redundant structure are first formed at the third height layer; and then the fourth via is formed, where one side of the fourth via is connected to the second redundant structure. Then, the fourth metal structure and the fourth redundant structure are formed at the fifth height layer, and the fourth redundant structure is connected to the other side of the fourth via.

Optionally, a plurality of second redundant structures may be formed, and a fourth via may be formed between two adjacent second redundant structures. Some or all areas of the two adjacent second redundant structures overlap, and a spacing between the two second redundant structures is less than the eighth threshold. An implementation of forming the fourth via between the two adjacent second redundant structures is similar to the foregoing description, and details are not described herein again.

Alternatively, a plurality of fourth redundant structures may be formed, and a fourth via may be formed between two adjacent fourth redundant structures. Some or all areas of the two adjacent fourth redundant structures overlap, and a spacing between the two fourth redundant structures is less than the eighth threshold. An implementation of forming the fourth via between the two adjacent fourth redundant structures is similar to the foregoing description, and details are not described herein again.

According to the memory preparation method in FIG. 11, the first redundant array with the same stacked structure may be used, so that an ambient environment of an edge part of the first storage array is consistent with an ambient environment of a central part of the first storage array, to avoid a deviation caused by a photolithography process. In addition, according to the method, a structure of each height layer may be even, thereby increasing smoothness of the layer after a CMP process. In addition, in the method, plasma generated in a process may be further released through the first via and the second via, to avoid damage to a back end device.

An embodiment of this application further provides a memory. The memory includes a controller and the first storage array and the first redundant array in the foregoing embodiments of this application. The controller is electrically connected to the first storage array.

An embodiment of this application further provides an electronic device. The electronic device includes a circuit board and the memory in the foregoing embodiments of this application.

An embodiment of this application further provides an electronic device. The electronic device includes a circuit board, a controller, and the first storage array and the first redundant array in the foregoing embodiments of this application.

A person of ordinary skill in the art may be aware that, in combination with examples described in embodiments disclosed in this specification, units and algorithm steps may be implemented by electronic hardware or a combination of computer software and electronic hardware. Whether the functions are performed by hardware or software depends on particular applications and design constraint conditions of the technical solutions. A person skilled in the art may use different methods to implement the described functions for each particular application, but it should not be considered that the implementation goes beyond the scope of this application.

It may be clearly understood by a person skilled in the art that, for the purpose of convenient and brief description, for a detailed working process of the foregoing system, apparatus, and unit, refer to a corresponding process in the foregoing method embodiments. Details are not described herein again.

In several embodiments provided in this application, it should be understood that the disclosed system, apparatus, and method may be implemented in other manners. For example, the described apparatus embodiment is merely an example. For example, division into the units is merely logical function division and may be other division during actual implementation. For example, a plurality of units or components may be combined or integrated into another system, or some features may be ignored or not performed. In addition, the displayed or discussed mutual couplings or direct couplings or communication connections may be implemented through some interfaces. The indirect couplings or the communication connections between the apparatuses or units may be implemented in electronic, mechanical, or other forms.

The units described as separate parts may or may not be physically separate, and parts displayed as units may or may not be physical units, may be located in one position, or may be distributed on a plurality of network units. Some or all of the units may be selected based on actual requirements to achieve objectives of the solutions of embodiments.

In addition, functional units in embodiments of this application may be integrated into one processing unit, each of the units may exist alone physically, or two or more units are integrated into one unit.

When the functions are implemented in the form of a software functional unit and sold or used as an independent product, the functions may be stored in a computer-readable storage medium. Based on such an understanding, the technical solutions of this application essentially, or the part contributing to the conventional technology, or some of the technical solutions may be implemented in a form of a software product. The computer software product is stored in a storage medium, and includes several instructions for instructing a computer device (which may be a personal computer, a server, or a network device) to perform all or some of the steps of the methods described in the embodiments of this application. The foregoing storage medium includes any medium that can store program code, such as a USB flash drive, a removable hard disk, a read-only memory (Read-Only Memory, ROM), a random access memory (Random Access Memory, RAM), a magnetic disk, or an optical disc.

The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

## Claims

1. A memory, comprising a substrate, a first storage array, and a first redundant array, wherein
the first storage array comprises a stacked structure comprising at least one transistor and at least one capacitor unit, and the first storage array is configured to store data; and
heights of the first redundant array and the first storage array relative to the substrate are the same, the first redundant array comprises a stacked structure comprising at least one transistor and at least one capacitor unit, and the stacked structure of the first redundant array is the same as the stacked structure of the first storage array.

2. The memory according to claim 1, wherein each of the stacked structures of the first storage array and the first redundant array comprises an mTnC structure, the mTnC structure comprises m transistors and n capacitor units that are stacked, and m and n are positive integers greater than or equal to 1.

3. The memory according to claim 1 or 2, wherein the at least one transistor of the first storage array and the at least one transistor of the first redundant array are disposed at a same layer, and the at least one capacitor unit of the first storage array and the at least one capacitor unit of the first redundant array are disposed at a same layer.

4. The memory according to any one of claims 1 to 3, wherein each of the stacked structures of the first storage array and the first redundant array further comprises at least one of the following structures: a word line, a bit line, a plate line plane, or a pillar; and
any one of the at least one transistor is connected to the word line, the bit line, or the pillar; or
any one of the at least one capacitor unit is disposed at an intersection point between the plate line plane and the pillar.

5. The memory according to any one of claims 1 to 4, wherein the first storage array is electrically connected to an external circuit outside the memory, and the first redundant array is disposed in an open circuit or is not electrically connected to a circuit in the memory.

6. The memory according to any one of claims 1 to 5, wherein the memory further comprises a first metal structure, a first redundant structure, and a first via;
heights of the first metal structure and the first redundant structure relative to the substrate are the same, and the height of the first redundant structure relative to the substrate is lower than the height of the first redundant array relative to the substrate; and
the first via is configured to connect the first redundant structure and the first redundant array.

7. The memory according to any one of claims 1 to 6, wherein the memory further comprises a second metal structure, a second redundant structure, and a second via;
heights of the second metal structure and the second redundant structure relative to the substrate are the same, and the height of the second redundant structure relative to the substrate is higher than the height of the first redundant array relative to the substrate; and
the second via is configured to connect the second redundant structure and the first redundant array.

8. A memory preparation method, comprising:
forming a substrate of a memory; and
forming a first storage array and a first redundant array at a same height relative to the substrate, wherein the first storage array comprises a stacked structure comprising at least one transistor and at least one capacitor unit, the first storage array is configured to store data, the first redundant array comprises a stacked structure comprising at least one transistor and at least one capacitor unit, and the stacked structure of the first redundant array is the same as the stacked structure of the first storage array.

9. The method according to claim 8, wherein each of the stacked structures of the first storage array and the first redundant array comprises an mTnC structure, the mTnC structure comprises m transistors and n capacitor units that are stacked, and m and n are positive integers greater than or equal to 1.

10. The method according to claim 8 or 9, wherein the forming a first storage array and a first redundant array at a same height relative to the substrate comprises:
forming the at least one transistor of the first storage array and the at least one transistor of the first redundant array at a same layer of the first storage array and the first redundant array; and
forming the at least one capacitor unit of the first storage array and the at least one capacitor unit of the first redundant array at a same layer of the first storage array and the first redundant array.

11. The method according to any one of claims 8 to 10, wherein each of the stacked structures of the first storage array and the first redundant array further comprises at least one of the following structures: a word line, a bit line, a plate line plane, or a pillar; and
any one of the at least one transistor is connected to the word line, the bit line, or the pillar; or
any one of the at least one capacitor unit is disposed at an intersection point between the plate line plane and the pillar.

12. The method according to any one of claims 8 to 11, wherein the first storage array is electrically connected to an external circuit outside the memory, and the first redundant array is disposed in an open circuit or is not electrically connected to a circuit in the memory.

13. The method according to any one of claims 8 to 12, wherein before the forming a first storage array and a first redundant array at a same height relative to the substrate, the method further comprises:
forming a first metal structure and a first redundant structure at a same height relative to the substrate, wherein the height of the first redundant structure relative to the substrate is lower than the height of the first redundant array relative to the substrate; and
forming a first via, wherein the first via is configured to connect the first redundant structure and the first redundant array.

14. The method according to any one of claims 8 to 13, wherein the method further comprises:
forming a second via, wherein the second via is configured to connect a second redundant structure and the first redundant array; and
forming a second metal structure and the second redundant structure at a same height relative to the substrate, wherein the height of the second redundant structure relative to the substrate is higher than the height of the first redundant array relative to the substrate.

15. A memory, comprising a controller and the first storage array and the first redundant array according to any one of claims 1 to 7, wherein the controller is electrically connected to the first storage array.

16. An electronic device, comprising a circuit board and the memory according to any one of claims 1 to 7.

17. An electronic device, comprising a circuit board and the memory according to claim 15.
